# EUROPEAN PATENT APPLICATION

(11) **EP 4 797 328 A1**
(43) Date of publication of application: **26.08.2026**
(21) Application number: 24887357.2
(22) Date of filing: 27.05.2024
(51) Int. Cl.: H01L 23/522

(54) **INTEGRATED CIRCUIT AND PREPARATION METHOD THEREFOR, AND ELECTRONIC DEVICE**

(30) Priority: 07.11.2023 CN 202311486129
(71) Applicant: HUAWEI TECHNOLOGIES CO., LTD., Shenzhen 518129 (CN)
(72) Inventor: HONG, Zhongshan, Shenzhen, Guangdong 518129 (CN)
(74) Representative: Pfenning, Meinig & Partner mbB
(86) International application number: PCT/CN2024/095593
(87) International publication number: WO 2025/097733

(57) **Abstract**

Embodiments of this application disclose an integrated circuit and a preparation method therefor, and an electronic device, and relate to the field of semiconductor technologies. The integrated circuit includes a power delivery network, a semiconductor structure, a gate line, a first electrode, a power supply connection part, a first electrode contact part, a second electrode contact part, and an isolation layer. The power supply connection part is located between two adjacent semiconductor structures and is in contact with the power delivery network. The power supply connection part divides the gate line into a first sub-gate line and a second sub-gate line. The first electrode contact part and the second electrode contact part are located on two opposite sides of the power supply connection part. Both the first electrode contact part and the second electrode contact part are in contact with the first electrode. The isolation layer isolates the power supply connection part from the first sub-gate line and the second sub-gate line. The power supply connection part penetrates the isolation layer and is in contact with the first electrode contact part and/or the second electrode contact part. Disposing the isolation layer can reduce a risk of a short circuit and breakdown between the power supply connection part and the first sub-gate line and between the power supply connection part and the second sub-gate line, and improve reliability of the integrated circuit.

## Description

This application claims priority to Chinese Patent Application No. 202311486129.3, filed on November 7, 2023 and entitled "INTEGRATED CIRCUIT AND PREPARATION METHOD THEREFOR, AND ELECTRONIC DEVICE", which is incorporated herein by reference in its entirety.

### TECHNICAL FIELD

This application relates to the field of semiconductor technologies, and in particular, to an integrated circuit and a preparation method therefor, and an electronic device.

### BACKGROUND

With continuous miniaturization of semiconductor devices, a density of transistors in a chip is increasingly high. A backside power delivery network (backside power delivery network, BSPDN) technology and a buried power rail (buried power rail, BPR) technology are proposed to release more space, thereby alleviating micro-shrinking pressure faced by a metal interconnection. In addition, a micro-shrinking gain of a chip area can be further achieved, a current-resistance voltage drop (IR drop) can be improved, chip performance can be enhanced, and power consumption can be reduced. However, this technical solution has a problem of low reliability.

### SUMMARY

Embodiments of this application provide an integrated circuit and a preparation method therefor, and an electronic device, to improve reliability of the integrated circuit.

To achieve the foregoing objectives, the following technical solutions are used in embodiments of this application.

According to a first aspect, an integrated circuit is provided. The integrated circuit includes a power delivery network, a plurality of semiconductor structures, a gate line, a first electrode, a power supply connection part, a first electrode contact part, a second electrode contact part, and an isolation layer. The power delivery network has a first surface. The plurality of semiconductor structures are located on the first surface. The plurality of semiconductor structures extend in a first direction and are spaced apart in a second direction. Both the first direction and the second direction are parallel to the first surface, and intersect with each other. The gate line is disposed across the plurality of semiconductor structures, and the gate line extends in the second direction. The first electrode is in contact with the semiconductor structure. In the first direction, the first electrode is located on a side of the gate line. The power supply connection part is located between two adjacent semiconductor structures, and the power supply connection part is in contact with the power delivery network. The power supply connection part extends in the first direction, and divides the gate line into a first sub-gate line and a second sub-gate line. The first electrode contact part and the second electrode contact part are located on two opposite sides of the power supply connection part in the second direction. The first electrode contact part and the second electrode contact part are located on different first electrodes and are in contact with the corresponding first electrodes. The isolation layer is located at least on the two opposite sides of the power supply connection part in the second direction, and isolates the power supply connection part from the first sub-gate line and the second sub-gate line. The power supply connection part further penetrates the isolation layer, and is in contact with the first electrode contact part and/or the second electrode contact part.

According to the integrated circuit provided in some embodiments of this application, the isolation layer is disposed around the power supply connection part. The isolation layer can isolate the power supply connection part from the first sub-gate line, and isolate the power supply connection part from the second sub-gate line, to electrically insulate the power supply connection part from the first sub-gate line, and electrically insulate the power supply connection part from the second sub-gate line.

The isolation layer has a self-alignment function, and is configured to provide a self-alignment effect for the power supply connection part. In this way, after a trench that penetrates the gate line is formed between the two adjacent semiconductor structures through etching, the isolation layer may be first formed in the trench, and then the power supply connection part is formed in the trench. However, a material of the power supply connection part may be naturally filled in a region defined by the isolation layer based on the self-alignment effect provided by the isolation layer. In this way, there is no need to form an insulation layer in the trench, and there is no need to form a power via in the insulation layer, thereby avoiding a problem of high process difficulty caused by etching of the power via.

In addition, the isolation layer has a specific thickness, and the thickness is uniform. In this embodiment of this application, the insulation layer may be replaced with the isolation layer, so that there is a sufficient insulation distance between the power supply connection part and the first sub-gate line, and there is a sufficient insulation distance between the power supply connection part and the second sub-gate line. This can reduce a risk of short circuit or breakdown between the power supply connection part and the first sub-gate line, and between the power supply connection part and the second sub-gate line, and increase a breakdown voltage between the power supply connection part and the first sub-gate line, and between the power supply connection part and the second sub-gate line, thereby improving reliability of the integrated circuit.

In a possible design manner of the first aspect, the first electrode contact part, the second electrode contact part, and the power supply connection part are disposed at a same layer. In this way, the first electrode contact part, the second electrode contact part, and the power supply connection part can be formed synchronously in a same patterning process, thereby helping simplify a preparation process for the integrated circuit.

In a possible design manner of the first aspect, the power supply connection part is in contact and of an integrated structure with the first electrode contact part. Alternatively, the power supply connection part is in contact and of an integrated structure with the second electrode contact part. Alternatively, the power supply connection part is in contact and of an integrated structure with the first electrode contact part and the second electrode contact part. This can improve structural stability and electrical connection reliability between the power supply connection part and the first electrode contact part and/or the second electrode contact part, to avoid affecting electrical signal transmission between the power supply connection part and the first electrode contact part and/or the second electrode contact part. In addition, this further helps reduce difficulty in preparing the power supply connection part and the first electrode contact part and/or the second electrode contact part.

In a possible design manner of the first aspect, the first electrode contact part includes a first conductive layer and a first barrier layer, and the power supply connection part includes a second conductive layer and a second barrier layer. When the power supply connection part is in contact with the first electrode contact part, the first conductive layer and the second conductive layer are connected to each other and are of an integrated structure; and the first barrier layer and the second barrier layer are connected to each other and are of an integrated structure, and the first barrier layer and the second barrier layer jointly surround the first conductive layer and the second conductive layer. In this way, the first conductive layer and the second conductive layer can be used to reduce contact resistance between the first electrode contact part and the power supply connection part, and the first barrier layer and the second barrier layer can be used to improve adhesion between the first electrode contact part, the power supply connection part, and a surrounding structure.

In a possible design manner of the first aspect, the power supply connection part includes a second conductive layer and a second barrier layer, and the second electrode contact part includes a third conductive layer and a third barrier layer. When the power supply connection part is in contact with the second electrode contact part, the second conductive layer and the third conductive layer are connected to each other and are of an integrated structure; and the second barrier layer and the third barrier layer are connected to each other and are of an integrated structure, and the second barrier layer and the third barrier layer jointly surround the second conductive layer and the third conductive layer. In this way, the third conductive layer and the second conductive layer can be used to reduce contact resistance between the second electrode contact part and the power supply connection part, and the third barrier layer and the second barrier layer can be used to improve adhesion between the second electrode contact part, the power supply connection part, and a surrounding structure.

In a possible design manner of the first aspect, the first electrode contact part includes a first conductive layer and a first barrier layer, the power supply connection part includes a second conductive layer and a second barrier layer, and the second electrode contact part includes a third conductive layer and a third barrier layer. When the power supply connection part is in contact with the first electrode contact part and the second electrode contact part, the first conductive layer, the second conductive layer, and the third conductive layer are connected to each other and are of an integrated structure; the first barrier layer, the second barrier layer, and the third barrier layer are connected to each other and are of an integrated structure; and the first barrier layer, the second barrier layer, and the third barrier layer jointly surround the first conductive layer, the second conductive layer, and the third barrier layer. In this way, the first conductive layer, the third conductive layer, and the second conductive layer can be used to reduce the contact resistance between the first electrode contact part, the second electrode contact part, and the power supply connection part; and the first barrier layer, the third barrier layer, and the second barrier layer can be used to improve adhesion between the first electrode contact part, the second electrode contact part, the power supply connection part, and a surrounding structure.

In a possible design manner of the first aspect, a material of the isolation layer includes at least one of silicon nitride, silicon carbide, silicon carbonitride, or silicon oxynitride.

In a possible design manner of the first aspect, a surface on a side that is of the isolation layer and that is close to the power delivery network is flush with a surface on a side that is of the power supply connection part and that is close to the power delivery network. In this way, the power supply connection part may be prepared in one step, and in a process of forming the power supply connection part, etching the isolation layer can be avoided. This helps simplify a preparation process for the integrated circuit and improve preparation efficiency of the integrated circuit.

In a possible design manner of the first aspect, the integrated circuit further includes a second electrode, a third electrode contact part, a fourth electrode contact part, and an interconnection layer. The second electrode is in contact with the semiconductor structure. In the first direction, the second electrode and the first electrode are located on two opposite sides of the gate line. The third electrode contact part and the fourth electrode contact part are located on two opposite sides of the power supply contact part in the second direction. The isolation layer isolates the power supply contact part from the third electrode contact part, and isolates the power supply contact part from the fourth electrode contact part. The third electrode contact part and the fourth electrode contact part are located on different second electrodes, and are in contact with the corresponding second electrodes. The interconnection layer is located on the third electrode contact part and the fourth electrode contact part, and is electrically connected to the third electrode contact part and the fourth electrode contact part. An electrical signal transmitted on the interconnection layer can be transmitted to the corresponding second electrode through the third electrode contact part, or to the corresponding second electrode through the fourth electrode contact part. The interconnection layer can be disposed to implement interconnection between elements (such as a transistor, a capacitor, and a resistor) on the power delivery network.

In a possible design manner of the first aspect, the third electrode contact part, the fourth electrode contact part, and the power supply connection part are disposed at a same layer. In this way, the third electrode contact part, the fourth electrode contact part, and the power supply connection part can be formed synchronously in a same patterning process, thereby helping simplify a preparation process for the integrated circuit.

In a possible design manner of the first aspect, the integrated circuit further includes at least two dummy gate lines. The dummy gate line extends in the second direction. The gate line is located between two adjacent dummy gate lines, and the power supply connection part further divides the dummy gate lines.

According to a second aspect, a preparation method for an integrated circuit is provided. The preparation method includes: forming an initial integrated circuit, where the initial integrated circuit includes a plurality of semiconductor structures, a first dielectric layer, a gate line, and a first electrode; the plurality of semiconductor structures extend in a first direction and are spaced apart in a second direction; the first dielectric layer is filled between two adjacent semiconductor structures; the gate line is disposed across the plurality of semiconductor structures and extends in the second direction; the first electrode is in contact with the semiconductor structure; and the first electrode is located on a side of the gate line in the first direction; forming a first trench between two adjacent semiconductor structures, where the first trench penetrates the gate line and the first dielectric layer; and the first trench extends in the first direction to cut the gate line into a first sub-gate line and a second sub-gate line; forming an isolation layer in the first trench, where the isolation layer covers a side wall of the first trench; forming an opening in the isolation layer; forming a power supply connection part, a first electrode contact part, and a second electrode contact part, where the power supply connection part is located in the first trench, and the first electrode contact part and the second electrode contact part are located on two opposite sides of the power supply connection part in the second direction; the first electrode contact part and the second electrode contact part are located on different first electrodes and are in contact with the corresponding first electrodes; and the power supply connection part is in contact with the first electrode contact part and/or the second electrode contact part through the opening; and forming a power delivery network on a side that is of the semiconductor structure and that is away from the gate line, where the power delivery network is in contact with the power supply connection part; and the power delivery network has a first surface, and both the first direction and the second direction are parallel to the first surface and intersect with each other.

According to the preparation method for an integrated circuit provided in this embodiment of this application, the isolation layer is formed in the first trench formed between two adjacent semiconductor structures, to provide a self-alignment effect for the power supply connection part subsequently formed in the first trench, so that a material of the power supply connection part is naturally filled in a region defined by the isolation layer. Difficulty in required processes such as alignment, photolithography, and etching is low, thereby helping increase a process window.

In addition, in this embodiment of this application, there is no need to etch the isolation layer to form a power via, thereby avoiding a problem caused by etching the power via. In other words, in this embodiment of this application, by using the isolation layer with a uniform thickness, the power supply connection part may be electrically insulated from the first sub-gate line, and the power supply connection part may be electrically insulated from the second sub-gate line. In addition, there may be a sufficient insulation distance between the power supply connection part and the first sub-gate line, and a sufficient insulation distance between the power supply connection part and the second sub-gate line. This can reduce a risk of short circuit or breakdown between the power supply connection part and the first sub-gate line, and between the power supply connection part and the second sub-gate line, and increase a breakdown voltage between the power supply connection part and the first sub-gate line, and between the power supply connection part and the second sub-gate line, thereby improving reliability of the integrated circuit.

In a possible design manner of the second aspect, the initial integrated circuit further includes a second dielectric layer. In the first direction, the second dielectric layer is located on two opposite sides of the gate line and covers the first electrode. Before forming the opening in the isolation layer, the preparation method further includes: forming a second trench in the second dielectric layer. The first electrode is exposed from the second trench. In the second direction, the second trench is located on two opposite sides of the isolation layer. The second trench communicates with the first trench through the opening. Forming the power supply connection part, the first electrode contact part, and the second electrode contact part includes: filling the first trench, the second trench, and the opening with a conductive material to form the power supply connection part, the first electrode contact part, and the second electrode contact part. The power supply connection part, the first electrode contact part, and the second electrode contact part are formed synchronously in a same patterning process, thereby helping simplify a preparation process for the integrated circuit. In addition, the power supply connection part, the first electrode contact part, and the second electrode contact part have simple structures, and are easy to prepare, thereby helping improve preparation efficiency of the integrated circuit.

In a possible design manner of the second aspect, before filling the first trench, the second trench, and the opening with the conductive material, the preparation method further includes: forming a barrier film that covers at least a side wall of the first trench, a side wall of the second trench, and a side wall of the opening. When the power supply connection part is in contact with the first electrode contact part, the barrier film surrounds the power supply connection part and the first electrode contact part. When the power supply connection part is in contact with the second electrode contact part, the barrier film surrounds the power supply connection part and the second electrode contact part. This helps simplify the preparation process for the integrated circuit, and can also improve adhesion between the conductive material and a dielectric layer (for example, the second dielectric layer) around the conductive material by using a second barrier film.

In a possible design manner of the second aspect, forming the isolation layer in the first trench includes: forming an isolation film, where the isolation film covers the gate line and the side wall and a bottom wall that are of the first trench; forming a third dielectric layer, where a portion of the third dielectric layer is filled in the first trench, and another portion of the third dielectric layer is located on a side that is of the isolation film and that is away from the gate line; and synchronously removing portions that are of the third dielectric layer and the isolation film and that are located on the gate line, and etching the portion that is of the third dielectric layer and that is filled in the first trench.

In a possible design manner of the second aspect, the initial integrated circuit further includes a substrate, where the substrate has a second surface and a third surface that are opposite to each other, and the semiconductor structure is located on the second surface; and the first trench further extends to the substrate. Before forming the power delivery network on the side that is of the semiconductor structure and that is away from the gate line, the preparation method further includes: removing the substrate from a side on which the third surface is located, to expose the power supply connection part. In this way, it can be ensured that, in the prepared integrated circuit, an end that is of the power supply connection part and that is close to the power delivery network is located in the first dielectric layer, thereby helping improve performance of the integrated circuit formed through preparation.

In a possible design manner of the second aspect, the initial integrated circuit further includes a second electrode, and the second electrode is in contact with the semiconductor structure. In the first direction, the second electrode and the first electrode are located on two opposite sides of the gate line. In a process of forming the power supply connection part, the first electrode contact part, and the second electrode contact part, a third electrode contact part and a fourth electrode contact part are further formed, where the third electrode contact part and the fourth electrode contact part are located on two opposite sides of the power supply connection part in the second direction; and the third electrode contact part and the fourth electrode contact part are located on different second electrodes and are in contact with the corresponding second electrodes. Before forming the power delivery network on the side that is of the semiconductor structure and that is away from the gate line, the preparation method further includes: forming an interconnection layer on the third electrode contact part and the fourth electrode contact part, where the interconnection layer is electrically connected to the third electrode contact part and the fourth electrode contact part. This helps simplify the preparation process for the integrated circuit, and can implement interconnection between elements (for example, a transistor, a capacitor, and a resistor) on the power delivery network.

According to a third aspect, an electronic device is provided. The electronic device includes a circuit board and the integrated circuit according to any implementation of the first aspect. The integrated circuit is connected to the circuit board.

For technical effects brought by any one of the designs in the third aspect, refer to the technical effects brought by different designs in the first aspect. Details are not described herein again.

### BRIEF DESCRIPTION OF DRAWINGS

FIG. 1 is a diagram of a structure of an electronic device according to an embodiment of this application;
FIG. 2 is a diagram of a partial structure of an electronic device according to an embodiment of this application;
FIG. 3 is a diagram of a structure of an integrated circuit according to an embodiment of this application;
FIG. 4 is a sectional view of the integrated circuit shown in FIG. 3 in a C-C direction;
FIG. 5a is a sectional view of the integrated circuit shown in FIG. 3 in a D-D direction;
FIG. 5b is another sectional view of the integrated circuit shown in FIG. 3 in a D-D direction;
FIG. 6 is a sectional view of the integrated circuit shown in FIG. 3 in an E-E direction;
FIG. 7 is a sectional view of the integrated circuit shown in FIG. 3 in an F-F direction;
FIG. 8 is a diagram of another structure of an integrated circuit according to an embodiment of this application;
FIG. 9 is a diagram of another structure of an integrated circuit according to an embodiment of this application;
FIG. 10 is a diagram of another structure of an integrated circuit according to an embodiment of this application;
FIG. 11 is a diagram of another structure of an integrated circuit according to an embodiment of this application;
FIG. 12 is a diagram of another structure of an integrated circuit according to an embodiment of this application;
FIG. 13 is a flowchart of a preparation method for an integrated circuit according to an embodiment of this application; and
FIG. 14a to FIG. 29b are diagrams of structures corresponding to steps in a preparation method for an integrated circuit according to an embodiment of this application.

### DESCRIPTION OF EMBODIMENTS

The following describes technical solutions in embodiments of this application with reference to accompanying drawings in embodiments of this application. It is clear that the described embodiments are merely a part but not all of embodiments of this application. All other embodiments obtained by a person of ordinary skill in the art based on embodiments of this application fall within the protection scope of this application.

In descriptions of embodiments of this application, unless otherwise specified, "a plurality of" means two or more. "At least one of items (pieces)" or an expression similar to the term indicates any combination of the items, and includes a single item (piece) or any combination of a plurality of items (pieces). For example, at least one item (piece) of a, b, and c may indicate a, b, c, a and b, a and c, b and c, or a, b, and c, where a, b, and c may be singular or plural.

"And/or" describes an association relationship between associated objects, and indicates that three relationships may exist. For example, a and/or b may indicate the following cases: Only a exists, both a and b exist, and only b exists, where a and b may be singular or plural. The character "/" generally indicates an "or" relationship between the associated objects.

In addition, to clearly describe the technical solutions in embodiments of this application, terms such as "first" and "second" are used in embodiments of this application to distinguish between same items or similar items that provide basically same functions or purposes. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to give an example, an illustration, or a description. Any embodiment or design solution described as an "example" or "for example" in embodiments of this application should not be explained as being more preferred or having more advantages than another embodiment or design solution. Exactly, use of the terms such as "example" or "for example" is intended to present a related concept in a specific manner for ease of understanding.

In descriptions of some embodiments, expressions of "connection" and extensions thereof are used. The term "connection" should be understood in a broad sense. For example, the "connection" may be a fixed connection, a detachable connection, or an integral connection, or may be a direct connection or an indirect connection implemented through an intermediate medium. In addition, use of "based on" means openness and inclusiveness, because a process, a step, calculation, or another action "based on" one or more conditions or values may be based in practice on additional conditions or values beyond the described values.

In embodiments of this application, "parallel", "perpendicular", "equal", and "flush" include described cases and cases similar with the described cases. A range of a similar case is within an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular" includes "absolutely perpendicular" and "approximately perpendicular", and an acceptable deviation range of "approximately perpendicular" may also be, for example, the deviation within 5°. "Equal" includes "absolutely equal" and "approximately equal", and an acceptable deviation range of "approximately equal" may be that, for example, a difference between two equal objects is less than or equal to 5% of either of the two objects. "Flush" includes "absolutely flush" and "approximately flush", and an acceptable deviation range of "approximately flush" may be determined, for example, based on an actual process.

In embodiments of this application, "upper", "lower", "front", and "right" may include but are not limited to being defined relative to illustrative orientations in which components are placed shown in the accompanying drawings. It should be understood that these orientation terms may be relative concepts and are used for relative descriptions and clarifications, and may vary accordingly based on a change of the orientations in which the components are placed in the accompanying drawings. In the accompanying drawings, for clarity, thicknesses of layers and regions are exaggerated, and a size proportion relationship between portions in the figures does not reflect an actual size proportion relationship. Thus, a change in a shape in the accompanying drawings due to, for example, preparation techniques and/or tolerances may be envisaged. Therefore, example implementations should not be explained as being limited to a shape of a region shown in this application, but rather include shape deviations due to, for example, preparation. For example, an etching region shown as a rectangle typically has a bending feature. Therefore, the regions shown in the accompanying drawings are essentially examples, and their shapes are not intended to show actual shapes of regions of a device, and are not intended to limit a scope of the example implementations.

In addition, an architecture and a scenario described in embodiments of this application are intended to describe the technical solutions in embodiments of this application more clearly, and do not constitute a limitation on the technical solutions provided in embodiments of this application. A person of ordinary skill in the art may learn that, with evolution of architectures and emergence of new scenarios, the technical solutions provided in embodiments of this application are also applicable to a similar technical problem.

An embodiment of this application provides an electronic device. The electronic device may be a mobile phone (mobile phone), a tablet computer (pad), a television, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a smart wearable device (for example, a smartwatch or a smart band), a vehicle-mounted device, a smart home device, a smart city device, and/or the like. A specific type of the electronic device is not specifically limited in embodiments of this application.

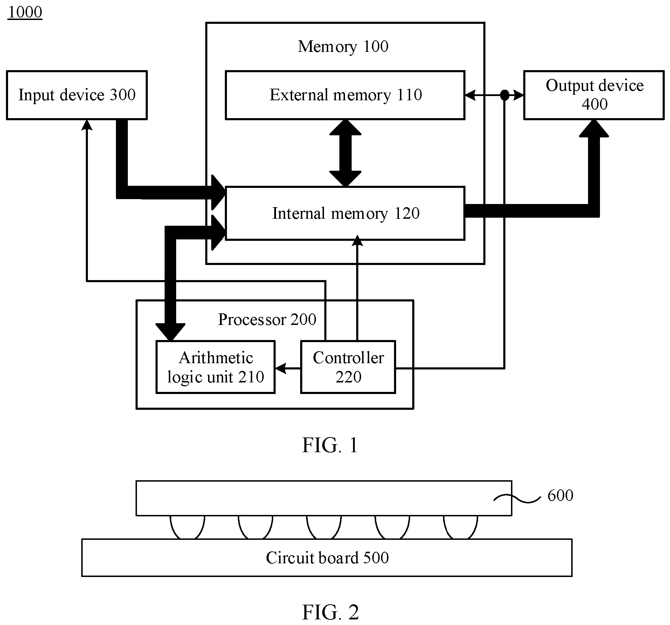

FIG. 1 is a diagram of a structure of an electronic device according to an embodiment of this application. As shown in FIG. 1, the electronic device 1000 includes components such as a memory 100, a processor 200, an input device 300, and an output device 400. A person skilled in the art may understand that a structure of the electronic device shown in FIG. 1 does not constitute any limitation on the electronic device 1000. The electronic device 1000 may include more or fewer components than those shown in FIG. 1, may combine some of the components shown in FIG. 1, or may have a different component arrangement from that shown in FIG. 1.

The memory 100 is configured to store a software program and a module. The memory 100 mainly includes a program storage region and a data storage region. The program storage region may store an operating system, an application required by at least one function (for example, a sound playing function and an image playing function), and the like. The data storage region may store data (for example, audio data, image data, and a phone book) created based on use of the electronic device, and the like. In addition, the memory 100 includes an external memory 110 and an internal memory 120. Data stored in the external memory 110 and the internal memory 120 may be transmitted to each other. The external memory 110 includes, for example, a hard disk, a USB flash drive, and a floppy disk. The internal memory 120 includes, for example, a static random access memory (static random access memory, SRAM), a dynamic random access memory (dynamic random access memory, DRAM), a read-only memory, and the like.

The processor 200 is a control center of the electronic device 1000, is connected to various portions of the entire electronic device 1000 through various interfaces and lines, and executes various functions of the electronic device 1000 and processes data by running or executing the software program and/or the module that are stored in the memory 100 and invoking data stored in the memory 100, to perform overall monitoring on the electronic device 1000. Optionally, the processor 200 may include one or more processing units. For example, the processor 200 may include a central processing unit (central processing unit, CPU), an artificial intelligence (artificial intelligence, AI) processor, a digital signal processor (digital signal processor, DSP), and a neural-network processing unit, or may be another application-specific integrated circuit (application-specific integrated circuit, ASIC). In FIG. 1, an example in which the processor 200 is a CPU is used, and the CPU may include an arithmetic logic unit 210 and a controller 220. The arithmetic logic unit 210 obtains data stored in the internal memory 120, and processes the data stored in the internal memory 120. A processed result is usually sent back to the internal memory 120. The controller 220 may control the arithmetic logic unit 210 to process the data, and the controller 220 may further control the external memory 110 and the internal memory 120 to store data or read data. The memory 100 may store data generated by the processor 200.

The input device 300 is configured to: receive input number or character information, and generate a button signal input related to a user setting and function control of the electronic device 1000. For example, the input device 300 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any suitable object or accessory like a finger or a stylus), and drive a corresponding connection apparatus based on a preset program. Optionally, the touchscreen may include two portions: a touch detection apparatus and a touch controller. The touch detection apparatus detects a touch orientation of the user, detects a signal generated by the touch operation, and transmits the signal to the touch controller. The touch controller receives touch information from the touch detection apparatus, converts the touch information into touch point coordinates, and sends the touch point coordinates to the processor 200, and can receive and execute a command sent by the processor 200. In addition, the touchscreen may be implemented in a plurality of types such as a resistive type, a capacitive type, an infrared ray type, and a surface acoustic wave type. The another input device may include but is not limited to one or more of a physical keyboard, a function button (for example, a volume control button or a power button), a trackball, a mouse, a joystick, and the like. The controller 220 in the processor 200 may further control the input device 300 to receive an input signal or not to receive an input signal. In addition, the input number or character information received by the input device 300 and the button signal input related to the user setting and the function control of the electronic device may be stored in the internal memory 120.

The output device 400 is configured to output a signal corresponding to data that is input by the input device 300 and that is stored in the internal memory 120. For example, the output device 400 outputs a sound signal or a video signal. The controller 220 in the processor 200 may further control the output device 400 to output a signal or not to output a signal.

It should be noted that a bold arrow in FIG. 1 indicates data transmission, and a direction of the bold arrow indicates a data transmission direction. For example, a unidirectional arrow between the input device 300 and the internal memory 120 indicates that data received by the input device 300 is transmitted to the internal memory 120. For another example, a bidirectional arrow between the arithmetic logic unit 210 and the internal memory 120 indicates that the data stored in the internal memory 120 may be transmitted to the arithmetic logic unit 210, and data processed by the arithmetic logic unit 210 may be transmitted to the internal memory 120. A thin arrow in FIG. 1 indicates a component that can be controlled by the controller 220. For example, the controller 220 may control the external memory 110, the internal memory 120, the arithmetic logic unit 210, the input device 300, the output device 400, and the like.

Optionally, the electronic device 1000 shown in FIG. 1 may further include various sensors, for example, a gyroscope sensor, a hygrometer sensor, an infrared sensor, and a magnetometer sensor. Details are not described herein. Optionally, the electronic device 1000 may further include a wireless fidelity (wireless fidelity, Wi-Fi) module, a Bluetooth module, and the like. Details are not described herein.

FIG. 2 is a diagram of a partial structure of an electronic device according to an embodiment of this application. As shown in FIG. 2, the electronic device 1000 includes a circuit board 500 and an integrated circuit 600. The integrated circuit 600 is disposed on the circuit board 500, and is electrically connected to the circuit board 500.

As shown in FIG. 2, the electronic device 1000 further includes a connection member disposed between the circuit board 500 and the integrated circuit 600, and the integrated circuit 600 is electrically connected to the circuit board 500 through the connection member. The connection member may be, for example, a ball grid array (ball grid array, BGA).

Optionally, another structure, for example, a package substrate, may be further disposed between the connection member and the circuit board 500. In other words, the integrated circuit 600 may be packaged on the package substrate, and then connected to the circuit board 500 through the package substrate.

There may be one or more integrated circuits 600. When there are a plurality of integrated circuits 600, the plurality of integrated circuits 600 may be tiled on the circuit board 500, or may be stacked on the circuit board 500.

The integrated circuit 600 may be a wafer, or may be a chip. When the integrated circuit 600 is a chip, the chip may be a bare die (which may also be referred to as a die or a particle) obtained by cutting a wafer, or may be a packaged chip obtained by packaging a bare die. Optionally, the integrated circuit 600 has a logical computing function. In this case, the integrated circuit 600 may be used in a logic device (for example, the arithmetic logic unit 210, the controller 220, and the sensor). Alternatively, the integrated circuit 600 has a storage function. In this case, the integrated circuit 600 may also be used in a storage device (for example, the external memory 110 and the internal memory 120). This is not limited in embodiments of this application.

Some embodiments of this application provide an integrated circuit and a preparation method therefor. With reference to accompanying drawings, the following separately schematically describes the integrated circuit and the preparation method for the integrated circuit.

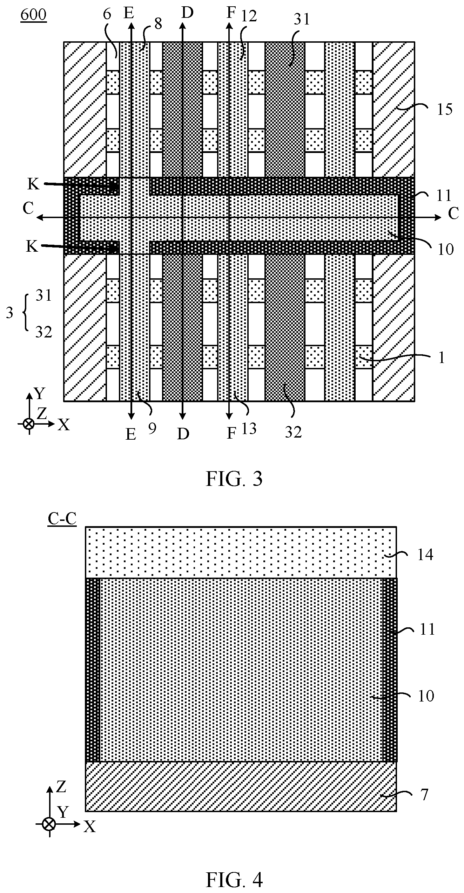

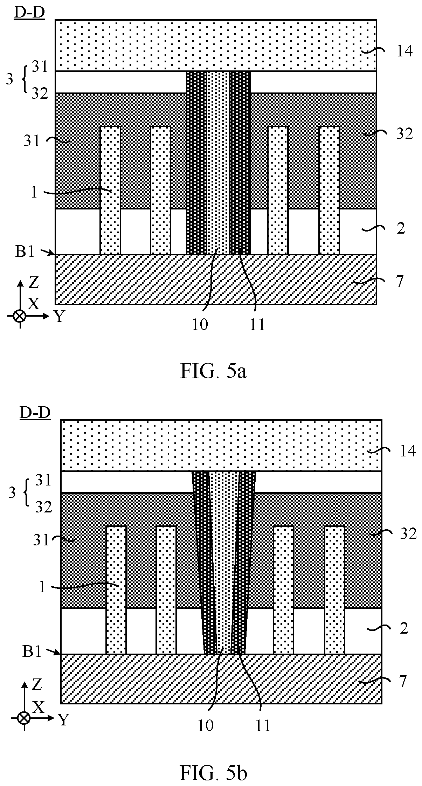

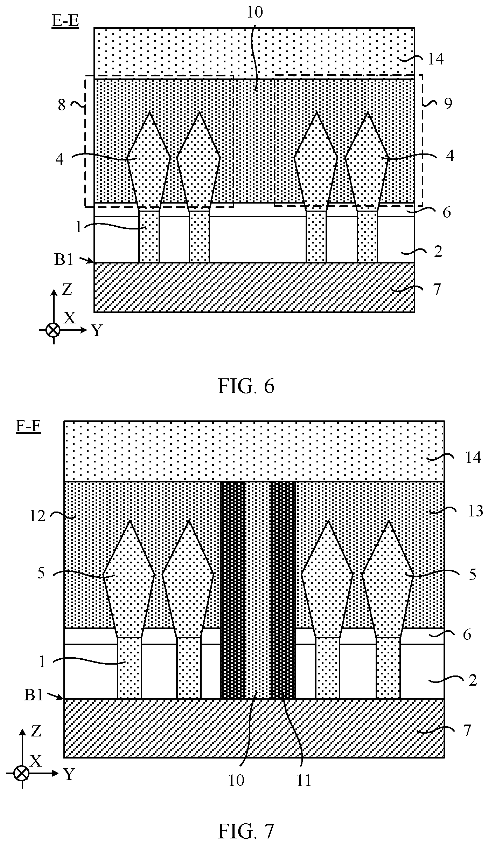

FIG. 3, and FIG. 8 to FIG. 12 respectively show structures of an integrated circuit. FIG. 4 shows a cross-sectional structure of the integrated circuit shown in FIG. 3 in a reference direction C-C. FIG. 5a and FIG. 5b respectively show cross-sectional structures of the integrated circuit shown in FIG. 3 in a reference direction D-D. FIG. 6 shows a cross-sectional structure of the integrated circuit shown in FIG. 3 in a reference direction E-E. FIG. 7 shows a cross-sectional structure of the integrated circuit shown in FIG. 3 in a reference direction F-F.

With reference to FIG. 3 to FIG. 7, the integrated circuit 600 includes a semiconductor structure 1, a first dielectric layer 2, a gate line 3, a first electrode 4, a second electrode 5, a second dielectric layer 6, and a power delivery network 7.

As shown in FIG. 3, FIG. 5a, and FIG. 5b, there may be a plurality of semiconductor structures 1. For example, the plurality of semiconductor structures 1 extend in a first direction X and are spaced apart in a second direction Y. In the plurality of semiconductor structures 1, a spacing between any two adjacent semiconductor structures 1 may be equal or unequal in the second direction Y. Sizes of the semiconductor structures 1 may be the same or unequal in the second direction Y. Sizes (which may also be referred to as heights) of the semiconductor structures 1 may be equal or unequal in a third direction Z. This may be specifically set depending on an actual requirement. Any two of the first direction X, the second direction Y, and the third direction Y are perpendicular to each other.

A quantity of semiconductor structures 1 may be set depending on an actual requirement. This is not limited in embodiments of this application, provided that a function and a structure requirement of the integrated circuit 600 can be met. For example, FIG. 3 shows four semiconductor structures 1.

The semiconductor structure 1 may be disposed in a plurality of manners, and may be disposed depending on an actual requirement. For example, as shown in FIG. 5a, the semiconductor structure 1 is disposed in a fin shape. For another example, the semiconductor structure 1 is a nanosheet (Nanosheet) structure. Optionally, when the semiconductor structure 1 is a nanosheet structure, the semiconductor structure 1 includes a plurality of nanosheets that are spaced apart and stacked in the third direction Z, and a plane on which each nanosheet is located is parallel to the first direction X and the second direction Y.

As shown in FIG. 5a to FIG. 7, the first dielectric layer 2 is located between any two adjacent semiconductor structures 1. Herein, the first dielectric layer 2 may also be referred to as a shallow trench isolation (shallow trench isolation, STI) structure, and is configured to isolate two adjacent semiconductor structures 1, to isolate adjacent devices. In FIG. 5a to FIG. 7, a lower surface of each semiconductor structure 1 is flush with a lower surface of the first dielectric layer 2. Optionally, the first dielectric layer 2 alternatively covers each semiconductor structure 1.

As shown in FIG. 5a and FIG. 5b, the gate line 3 is located on the first dielectric layer 2, and is disposed across a plurality of semiconductor structures 1. For example, there are three, six, eight, or even more semiconductor structures 1 across which the gate line 3 is disposed.

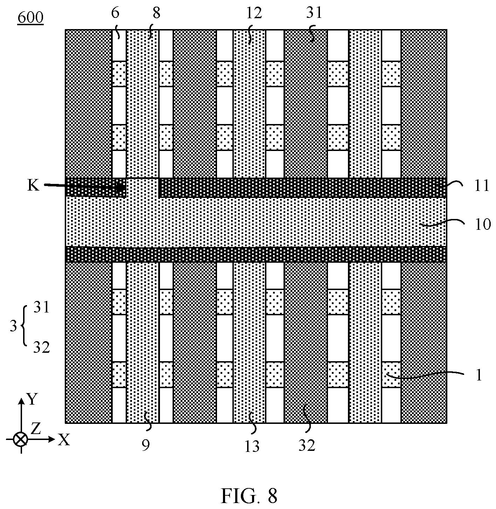

There are a plurality of gate lines 3. For example, the plurality of gate lines 3 extend in the second direction Y and are spaced apart in the first direction X. In the plurality of gate lines 3, spacings between any two adjacent gate lines 3 may be equal or unequal. This may be specifically set depending on an actual requirement. A quantity of semiconductor structures 1 across which different gate lines 3 are disposed may be equal or unequal, and may be specifically set depending on an actual requirement. A quantity of gate lines 3 may be set depending on an actual requirement. This is not limited in embodiments of this application, provided that a function and a structure requirement of the integrated circuit 600 can be met. For example, FIG. 3 shows two gate lines 3, and FIG. 8 shows four gate lines 3. Each gate line 3 is disposed across four semiconductor structures 1.

With reference to FIG. 3, FIG. 6, and FIG. 7, both the first electrode 4 and the second electrode 5 are in contact with the semiconductor structure 1, and the first electrode 4 and the second electrode 5 are located on two opposite sides of the gate line 3 in the first direction X. For example, the first electrode 4 and the second electrode 5 may be formed on the semiconductor structure 1 by using an epitaxial process. One of the first electrode 4 and the second electrode 5 may be a source electrode, and the other may be a drain electrode. This may be specifically set depending on an actual requirement. Optionally, the first electrode 4 is a source electrode, and the second electrode 5 is a drain electrode.

The first electrode 4 and the second electrode 5 are disposed with the semiconductor structure 1 in a plurality of manners, and may be disposed depending on an actual requirement. For example, with reference to FIG. 3, FIG. 6, and FIG. 7, the semiconductor structure 1 is bar-shaped, a plurality of gate lines 3 are disposed across each semiconductor structure 1, and both the first electrode 4 and the second electrode 5 are located on the semiconductor structure 1. For another example, one gate line 3 is disposed across each semiconductor structure 1, a plurality of semiconductor structures 1 are spaced apart in the first direction X, and the first electrode 4 or the second electrode 5 is disposed between two adjacent semiconductor structures 1.

With reference to FIG. 5a, FIG. 6, and FIG. 7, a portion that is of the gate line 3 and that is disposed across the semiconductor structure 1 is configured to form a gate electrode, a portion that is of the semiconductor structure 1 and that is covered by the gate line 3 is configured to form a channel, and the gate electrode, the channel, and the first electrode 4 and the second electrode 5 that are located on two sides of the gate electrode are configured to form a transistor. When the semiconductor structure 1 is disposed in a fin shape, the transistor may be a fin field-effect transistor. When the semiconductor structure 1 is a nanosheet structure, the transistor may be a gate-all-around field-effect transistor (which may also be referred to as a field-effect transistor of a gate-all-around nanosheet structure). In other words, a same gate line 3 and a plurality of semiconductor structures 1 across which the same gate line 3 is disposed may form a plurality of transistors, and the gate line 3 may simultaneously control on or off of the plurality of transistors.

As shown in FIG. 3, the second dielectric layer 6 is located on the first dielectric layer 2, and is disposed across the plurality of semiconductor structures 1. There are a plurality of second dielectric layers 6. For example, the plurality of second dielectric layers 6 extend in the second direction Y and are spaced apart in the first direction X. The second dielectric layer 6 and the gate line 3 are alternately disposed in the first direction X. In this way, it is convenient to isolate adjacent gate lines 3 by using the second dielectric layer 6.

As shown in FIG. 5a and FIG. 5b, the power delivery network 7 has a first surface B1. For example, the first surface B1 is a plane. The semiconductor structure 1 and the first dielectric layer 2 are located on the first surface B1 and are in contact with the first surface B1. Both the first direction X and the second direction Y are parallel to the first surface B1, and the third direction Y is perpendicular to the first surface B1. When the plurality of semiconductor structures 1 are spaced apart, and the first electrode 4 or the second electrode 5 is disposed between two adjacent semiconductor structures 1, the first electrode 4 and the second electrode 5 are also located on the first surface B1, and are in contact with the first surface B1.

The power delivery network 7 includes a plurality of fourth dielectric layers that are spaced apart in the third direction Z, and a first metal routing layer located between two adjacent fourth dielectric layers. Metal traces in different first metal routing layers may be connected by using vias in the fourth dielectric layer. For example, the power delivery network 7 includes components such as a power supply (VSS, VDD, or the like) and ground. For example, the power delivery network 7 may be electrically connected to the first electrode 4 of a transistor disposed on the first surface B1, to provide an operating voltage for the transistor.

In a possible implementation, a power supply connection structure is disposed in the integrated circuit, to connect the power delivery network 7 to the first electrode 4 of the transistor. In a process of forming the power supply connection structure, a deep hole that penetrates the gate line 3 and the first dielectric layer 2 is first formed between the two adjacent semiconductor structures through etching. Then, an insulation material is filled in the deep hole to form an insulation layer. Then, a power via (power via) is formed in the insulation layer, and a conductive material is filled in the power via to obtain the power supply connection structure.

However, processes such as alignment, photolithography, and etching required for forming the power via in the insulation layer are difficult. In addition, when a deviation occurs in the processes such as alignment, photolithography, and etching, a size of the power via and a spacing between the power via and the gate line 3 are affected. As a result, a short circuit may easily occur between the power supply connection structure and the gate line 3, or the power supply connection structure and the gate line 3 may be easily broken down due to an insufficient insulation distance. In this way, reliability of the integrated circuit is reduced.

Based on this, still refer to FIG. 3. The integrated circuit 600 provided in embodiments of this application further includes a first electrode contact part 8, a second electrode contact part 9, a power supply connection part 10, and an isolation layer 11.

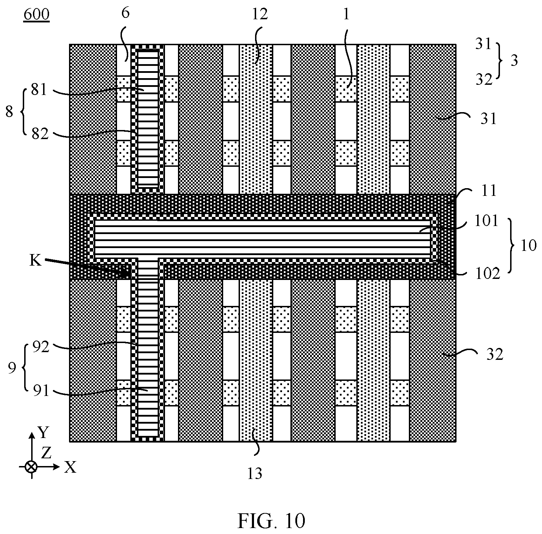

As shown in FIG. 3, FIG. 5a, and FIG. 5b, the power supply connection part 10 is located between two adjacent semiconductor structures 1. The power supply connection part 10 penetrates the gate line 3 and the first dielectric layer 2, and divides the gate line 3 into a first sub-gate line 31 and a second sub-gate line 32. The power supply connection part 10 extends in the first direction X, and an orthographic projection of the power supply connection part 10 on the first surface B1 is bar-shaped. The power supply connection part 10 can divide a plurality of gate lines 3. There may be two, three, four, or even more gate lines 3 divided by the power supply connection part 10. For example, in FIG. 3, the power supply connection part 10 divides two gate lines 3. In FIG. 10, the power supply connection part 10 divides four gate lines 3. In FIG. 8, the power supply connection part 10 divides at least four gate lines 3.

The power supply connection part 10 is in contact with (for example, in direct contact with) the power delivery network 7, to form an electrical connection. The operating voltage provided by the power delivery network 7 can be transmitted to the power supply connection part 10. A structure of the power supply connection part 10 is disposed as a bar-shaped structure, to help reduce resistance of the power supply connection part 10, reduce a voltage drop, and improve accuracy of the operating voltage transmitted by the power supply connection part 10.

As shown in FIG. 3 and FIG. 8, the first electrode contact part 8 and the second electrode contact part 9 are respectively located on two opposite sides of the power supply connection part 10 in the second direction Y. For example, in FIG. 3 and FIG. 8, in the second direction Y, the first electrode contact part 8 is located on an upper side of the power supply connection part 10, and the second electrode contact part 9 is located on a lower side of the power supply connection part 10.

The first electrode contact part 8 and the second electrode contact part 9 are located on different first electrodes 4, and are in contact with the corresponding first electrodes 4.

For example, with reference to FIG. 3 and FIG. 6, the first electrode contact part 8 penetrates the second dielectric layer 6 to the first electrode 4 located on the upper side of the power supply connection part 10. The first electrode contact part 8 is in contact with (for example, in direct contact with) the first electrode 4. There may be a plurality of first electrodes 4 in contact with a same first electrode contact part 8, and a specific quantity may be specifically set according to an actual product requirement. For example, in FIG. 3 and FIG. 6, there are two first electrodes 4 in contact with a same first electrode contact part 8.

The first electrode contact part 8 extends in the second direction Y. The first electrode contact part 8 is located on a side of the gate line 3 in the first direction X. For example, in FIG. 3, the first electrode contact part 8 is located on a left side of the gate line 3.

For example, with reference to FIG. 3 and FIG. 6, the second electrode contact part 9 penetrates the second dielectric layer 6 to the first electrode 4 located on the lower side of the power supply connection part 10. The second electrode contact part 9 is in contact with (for example, in direct contact with) the first electrode 4. There may be a plurality of first electrodes 4 in contact with a same second electrode contact part 9, and a specific quantity may be specifically set according to an actual product requirement. For example, in FIG. 3 and FIG. 6, there are two first electrodes 4 in contact with a same second electrode contact part 9.

The second electrode contact part 9 extends in the second direction Y. The second electrode contact part 9 is located on a side of the gate line 3 in the first direction X. For example, in FIG. 3, the second electrode contact part 9 is located on the left side of the gate line 3. The first electrode contact part 8 and the second electrode contact part 9 may be located on a same side of the gate line 3, or may be located on different sides of the gate line 3.

For example, a transistor corresponding to the first electrode 4 in contact with the first electrode contact part 8 is configured to form a standard unit (or a logic unit), and the transistor corresponding to the first electrode 4 in contact with the second electrode contact part 9 is configured to form a standard unit. The two standard units are different standard units. Correspondingly, it may also be considered that the power supply connection part 10 is located between two adjacent standard units. The transistor corresponding to the first electrode 4 in contact with the first electrode contact part 8 and the transistor corresponding to the first electrode 4 in contact with the second electrode contact part 9 may both be N-type transistors, or may both be P-type transistors.

As shown in FIG. 3, FIG. 5a, and FIG. 5b, the isolation layer 11 is located at least on two opposite sides of the power supply connection part 10 in the second direction Y, and isolates the power supply connection part 10 from the first sub-gate line 31 and the second sub-gate line 32. A material of the isolation layer 11 includes a dielectric material, to electrically insulate the power supply connection part 10 from the first sub-gate line 31, and electrically isolate the power supply connection part 10 from the second sub-gate line 32. The dielectric material includes but is not limited to one or more of silicon nitride (SiN), silicon carbide (SiC), silicon carbonitride (SiNC), and silicon oxynitride (SiNO). The isolation layer 11 may be a structure including a single layer of film, or may be a structure formed by stacking a plurality of film layers.

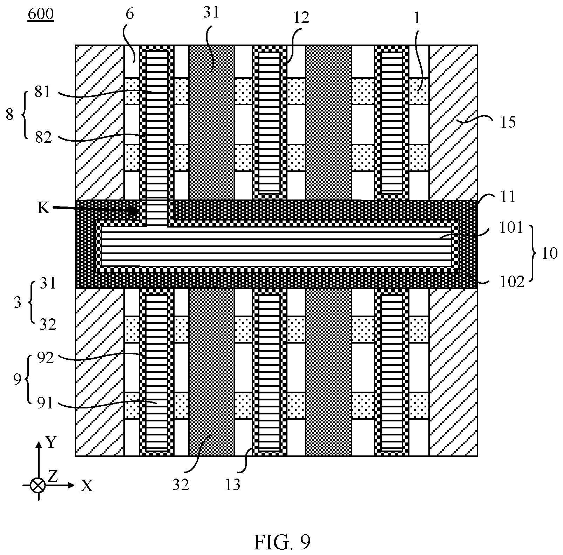

The power supply connection part 10 further penetrates the isolation layer 11, and is in contact with the first electrode contact part 8 and/or the second electrode contact part 9. In other words, as shown in FIG. 8 and FIG. 9, the power supply connection part 10 may penetrate the isolation layer 11 and be in contact with (for example, in direct contact with) the first electrode contact part 8, to form an electrical connection. In this case, the operating voltage provided by the power delivery network 7 may be sequentially transmitted to the first electrode 4 electrically connected to the first electrode contact part 8 through the power supply connection part 10 and the first electrode contact part 8. Alternatively, as shown in FIG. 10, the power supply connection part 10 may penetrate the isolation layer 11 and be in contact with (for example, in direct contact with) the second electrode contact part 9, to form an electrical connection. In this case, an operating voltage provided by the power delivery network 7 may be sequentially transmitted to the first electrode 4 electrically connected to the second electrode contact part 9 through the power supply connection part 10 and the second electrode contact part 9. Alternatively, as shown in FIG. 3, FIG. 11, and FIG. 12, the power supply connection part 10 may penetrate the isolation layer 11 and be in contact with both the first electrode contact part 8 and the second electrode contact part 9, to form an electrical connection. In this case, an operating voltage provided by the power delivery network 7 may be simultaneously transmitted to the first electrode 4 electrically connected to the first electrode contact part 8 and the first electrode 4 electrically connected to the second electrode contact part 9 through the power supply connection part 10, the first electrode contact part 8, and the second electrode contact part 9. A connection relationship among the power supply connection part 10, the first electrode contact part 8, and the second electrode contact part 9 may be determined according to an actual product requirement. This is not limited in embodiments of this application.

A position relationship between the isolation layer 11 and the power supply connection part 10 is related to the connection relationship among the power supply connection part 10, the first electrode contact part 8, and the second electrode contact part 9.

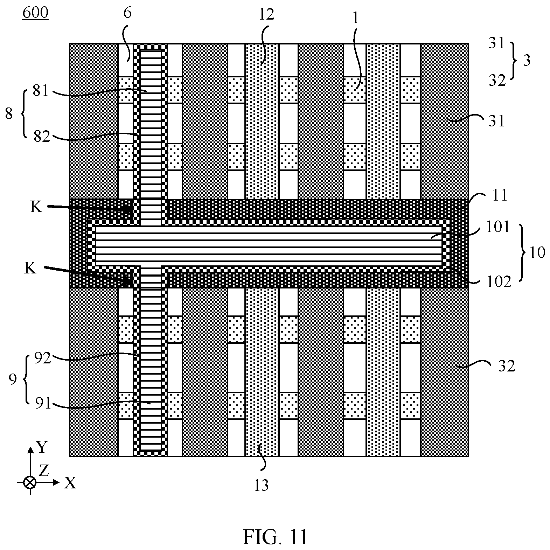

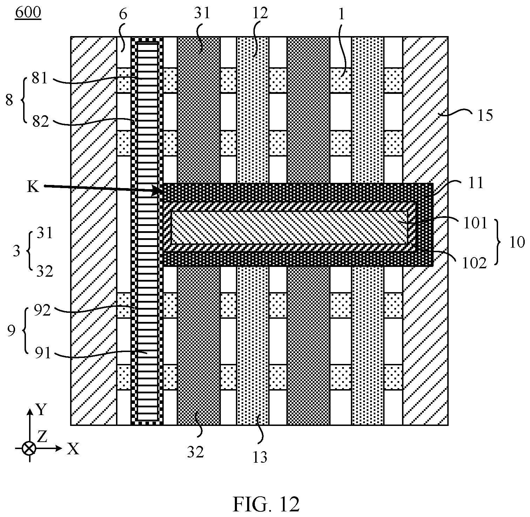

Optionally, as shown in FIG. 3, FIG. 11, and FIG. 12, the power supply connection part 10 is in contact with both the first electrode contact part 8 and the second electrode contact part 9. In this case, at least one opening K is provided in the isolation layer 11. For example, in FIG. 12, an opening K is provided in the isolation layer 11. For example, the opening K is located on a left side of the power supply connection part 10 shown in FIG. 12. A portion of the power supply connection part 10 extends into the opening K, to electrically connect to the first electrode contact part 8 and the second electrode contact part 9. Alternatively, as shown in FIG. 3 and FIG. 11, two openings K are provided in the isolation layer 11. One of the openings K is located on a side that is of the power supply connection part 10 and that is close to the first electrode contact part 8, and a portion of the power supply connection part 10 extends into the opening K, to electrically connect to the first electrode contact part 8. The other opening K is located on a side that is of the power supply connection part 10 and that is close to the second electrode contact part 9, and a portion of the power supply connection part 10 extends into the opening K, to electrically connect to the second electrode contact part 9. In the third direction Z, a size of the opening K is less than or equal to a size of the isolation layer 11. For example, an orthographic projection of the isolation layer 11 on the first surface B1 is in a shape of an open ring or in a shape of two U-shaped patterns disposed opposite to each other, and is disposed around the power supply connection part 10.

Optionally, as shown in FIG. 8 and FIG. 9, the power supply connection part 10 is in contact with the first electrode contact part 8. In this case, an opening K is provided in the isolation layer 11, and the opening K is located on a side that is of the power supply connection part 10 and that is close to the first electrode contact part 8. A portion of the power supply connection part 10 extends into the opening K, to electrically connect to the first electrode contact part 8. In the third direction Z, a size of the opening K is less than or equal to a size of the isolation layer 11. For example, an orthographic projection of the isolation layer 11 on the first surface B1 is in a shape of an open ring, and is disposed around the power supply connection part 10.

Optionally, as shown in FIG. 10, the power supply connection part 10 is in contact with the second electrode contact part 9. In this case, an opening K is provided in the isolation layer 11, and the opening K is located on a side that is of the power supply connection part 10 and that is close to the second electrode contact part 9. A portion of the power supply connection part 10 extends into the opening K, to electrically connect to the second electrode contact part 9. In the third direction Z, a size of the opening K is less than or equal to a size of the isolation layer 11. For example, an orthographic projection of the isolation layer 11 on the first surface B1 is in a shape of an open ring, and is disposed around the power supply connection part 10.

It may be understood that the isolation layer 11 is configured to provide a self-alignment effect for the power supply connection part 10. In this way, after a trench that penetrates the gate line 3 and the first dielectric layer 2 is formed between two adjacent semiconductor structures 1 through etching, the isolation layer 11 may be first formed in the trench, and then the power supply connection part 10 is formed in the trench. However, a material of the power supply connection part 10 may be naturally filled in a region defined by the isolation layer 11 based on the self-alignment effect provided by the isolation layer 11. In this way, there is no need to form an insulation layer in the trench, and there is no need to form a power via in the insulation layer, thereby avoiding a problem of high process difficulty caused by etching of the power via.

In addition, the isolation layer 11 has a specific thickness, and the thickness is uniform. In this embodiment of this application, the insulation layer is replaced with the isolation layer 11. By using the isolation layer 11, the power supply connection part 10 is electrically insulated from the first sub-gate line 31, and the power supply connection part 10 is electrically insulated from the second sub-gate line 32. There is a sufficient insulation distance between the power supply connection part 10 and the first sub-gate line 31, and a sufficient insulation distance between the power supply connection part 10 and the second sub-gate line 32. This can reduce a risk of short circuit or breakdown between the power supply connection part 10 and the first sub-gate line 31, and between the power supply connection part 10 and the second sub-gate line 32, and increase a breakdown voltage between the power supply connection part 10 and the first sub-gate line 31, and between the power supply connection part 10 and the second sub-gate line 32, thereby improving reliability of the integrated circuit 600.

In some examples, as shown in FIG. 5a and FIG. 5b, a surface that is of the isolation layer 11 and that is close to the power delivery network 7 is flush with a surface that is of the power supply connection part 10 and that is close to the power delivery network 7. An end that is of the power supply connection part 10 and that is close to the power delivery network 7 does not protrude from the isolation layer 11 or retract into the isolation layer 11.

In this way, the power supply connection part 10 may be prepared in one step, and in a process of forming the power supply connection part 10, etching the isolation layer 11 can be avoided. This helps simplify a preparation process for the integrated circuit 600 and improve preparation efficiency of the integrated circuit 600.

Further, as shown in FIG. 5a and FIG. 5b, a surface that is of the isolation layer 11 and that is away from the power delivery network 7 is flush with a surface that is of the power supply connection part 10 and that is away from the power delivery network 7. Correspondingly, in the third direction Z, a maximum size of the isolation layer 11 is equal to a maximum size of the power supply connection part 10. A cross-sectional pattern of the power supply connection part 10 may be a rectangle (as shown in FIG. 5a), or may be an inverted trapezoid (as shown in FIG. 5b), and may be specifically determined based on an actual preparation process. The cross section is perpendicular to the first direction X.

In some embodiments, as shown in FIG. 3, and FIG. 8 to FIG. 11, the first electrode contact part 8, the second electrode contact part 9, and the power supply connection part 10 are disposed at a same layer.

The "same layer" mentioned in this specification refers to that a film layer used to form a specific pattern is formed by using a same film forming process, and then a layer structure is formed by using a single patterning process. Based on different specific patterns, the single patterning process may include a plurality of etching processes or grinding processes. Specific patterns in the formed layer structure may be continuous or discontinuous, and these specific patterns may also be at different heights or have different thicknesses.

In other words, the first electrode contact part 8, the second electrode contact part 9, and the power supply connection part 10 are formed by performing patterning on a same film. Correspondingly, the first electrode contact part 8, the second electrode contact part 9, and the power supply connection part 10 have a same material and a same structure. In this way, the first electrode contact part 8, the second electrode contact part 9, and the power supply connection part 10 can be formed synchronously in a same patterning process, thereby helping simplify a preparation process of the integrated circuit 600.

Optionally, as shown in FIG. 8 and FIG. 9, when the power supply connection part 10 is in contact with the first electrode contact part 8, the power supply connection part 10 and the first electrode contact part 8 are of an integrated structure. In other words, the power supply connection part 10 and the first electrode contact part 8 are integrally formed, the power supply connection part 10 and the first electrode contact part 8 are continuous, and there is no interface between the power supply connection part 10 and the first electrode contact part 8.

This can improve structural stability and electrical connection reliability between the power supply connection part 10 and the first electrode contact part 8, to avoid affecting electrical signal transmission between the power supply connection part 10 and the first electrode contact part 8. In addition, this helps reduce difficulty in preparing the power supply connection part 10 and the first electrode contact part 8.

Optionally, as shown in FIG. 10, when the power supply connection part 10 is in contact with the second electrode contact part 9, the power supply connection part 10 and the second electrode contact part 9 are of an integrated structure. In other words, the power supply connection part 10 and the second electrode contact part 9 are integrally formed, the power supply connection part 10 and the second electrode contact part 9 are continuous, and there is no interface between the power supply connection part 10 and the second electrode contact part 9.

This can improve structural stability and electrical connection reliability between the power supply connection part 10 and the second electrode contact part 9, to avoid affecting electrical signal transmission between the power supply connection part 10 and the second electrode contact part 9. In addition, this helps reduce difficulty in preparing the power supply connection part 10 and the second electrode contact part 9.

Optionally, as shown in FIG. 3 and FIG. 11, when the power supply connection part 10 is in contact with both the first electrode contact part 8 and the second electrode contact part 9, the power supply connection part 10, the first electrode contact part 8, and the second electrode contact part 9 are of an integrated structure. In other words, the power supply connection part 10, the first electrode contact part 8, and the second electrode contact part 9 are integrally formed, the power supply connection part 10, the first electrode contact part 8, and the second electrode contact part 9 are continuous, there is no interface between the power supply connection part 10 and the first electrode contact part 8, and there is no interface between the power supply connection part 10 and the second electrode contact part 9 either.

This can improve structural stability and electrical connection reliability between the power supply connection part 10 and both the first electrode contact part 8 and the second electrode contact part 9, to avoid affecting electrical signal transmission between the power supply connection part 10 and both the first electrode contact part 8 and the second electrode contact part 9. In addition, this helps reduce difficulty in preparing the power supply connection part 10, the first electrode contact part 8, and the second electrode contact part 9.

The first electrode contact part 8 has a plurality of structures that may be set depending on an actual requirement.

In some examples, as shown in FIG. 3 and FIG. 8, the first electrode contact part 8 includes a single layer of film. In this case, a material of the first electrode contact part 8 includes a conductive material. For example, the conductive material includes but is not limited to one or more of aluminum, copper, tungsten, molybdenum, cobalt, and the like.

In some other examples, the first electrode contact part 8 is formed by stacking a plurality of film layers. For example, as shown in FIG. 9 to FIG. 12, the first electrode contact part 8 includes the first conductive layer 81 and the first barrier layer 82. The first barrier layer 82 is disposed around the first conductive layer 81. In this case, the material of the first conductive layer 81 includes a conductive material. For example, the conductive material includes but is not limited to one or more of aluminum, copper, tungsten, molybdenum, cobalt, and the like. A material of the first barrier layer 82 includes but is not limited to one or more of titanium, titanium nitride, tantalum, tantalum nitride, and the like. In this way, the first conductive layer 81 can be used to reduce a contact resistance between the first electrode contact part 8 and a structure (for example, the power supply connection part 10) electrically connected to the first electrode contact part 8, and the first barrier layer 82 can be used to improve adhesion between the first electrode contact part 8 and a dielectric layer (for example, the second dielectric layer 6) around the first electrode contact part 8.

The second electrode contact part 9 has a plurality of structures that may be set depending on an actual requirement.

In some examples, as shown in FIG. 3 and FIG. 8, the second electrode contact part 9 includes a single layer of film. In this case, a material of the second electrode contact part 9 includes a conductive material. For example, the conductive material includes but is not limited to one or more of aluminum, copper, tungsten, molybdenum, cobalt, and the like.

In some other examples, the second electrode contact part 9 is formed by stacking a plurality of film layers. For example, as shown in FIG. 9 to FIG. 12, the second electrode contact part 9 includes a third conductive layer 91 and a third barrier layer 92. The third barrier layer 92 is disposed around the third conductive layer 91. In this case, a material of the third conductive layer 91 includes a conductive material. For example, the conductive material includes but is not limited to one or more of aluminum, copper, tungsten, molybdenum, cobalt, and the like. A material of the third barrier layer 92 includes but is not limited to one or more of titanium, titanium nitride, tantalum, tantalum nitride, and the like. In this way, the third conductive layer 91 can be used to reduce a contact resistance between the second electrode contact part 9 and a structure (for example, the power supply connection part 10) electrically connected to the second electrode contact part 9, and the third barrier layer 92 can be used to improve adhesion between the second electrode contact part 9 and a dielectric layer (for example, the second dielectric layer 6) around the second electrode contact part 9.

The structure of the first electrode contact part 8 may be the same as or different from the structure of the second electrode contact part 9. When the structure of the first electrode contact part 8 is the same as the structure of the second electrode contact part 9, the material of the first electrode contact part 8 may be the same as or different from the material of the second electrode contact part 9.

The power supply connection part 10 has a plurality of structures that may be set depending on an actual requirement.

In some examples, as shown in FIG. 3 and FIG. 8, the power supply connection part 10 includes a single layer of film. In this case, the material of the power supply connection part 10 includes a conductive material. For example, the conductive material includes but is not limited to one or more of aluminum, copper, tungsten, molybdenum, cobalt, and the like.

In some other examples, the power supply connection part 10 is formed by stacking a plurality of film layers. For example, as shown in FIG. 9 to FIG. 12, the power supply connection part 10 includes a second conductive layer 101 and a second barrier layer 102. The second barrier layer 102 is disposed around the second conductive layer 101. In this case, a material of the second conductive layer 101 includes a conductive material. For example, the conductive material includes but is not limited to one or more of aluminum, copper, tungsten, molybdenum, cobalt, and the like. The material of the second barrier layer 102 is one or more of titanium, titanium nitride, tantalum, tantalum nitride, and the like. In this way, the second conductive layer 101 can be used to reduce a contact resistance between the power supply connection part 10 and a structure (for example, the power delivery network 7, the first electrode contact part 8, and the second electrode contact part 9) electrically connected to the power supply connection part 10, and the second barrier layer 102 can be used to improve adhesion between the power supply connection part 10 and a dielectric layer (for example, the isolation layer 11) around the power supply connection part 10.

The structure of the power supply connection part 10 may be the same as or different from the structure of the first electrode contact part 8 and the structure of the second electrode contact part 9. When the structure of the power supply connection part 10 is the same as the structure of the first electrode contact part 8 and the structure of the second electrode contact part 9, the material of the power supply connection part 10 may be the same as or different from the material of the first electrode contact part 8 and the material of the second electrode contact part 9.

It may be understood that the structure of the power supply connection part 10, the structure of the first electrode contact part 8, and the structure of the second electrode contact part 9 are disposed in a plurality of combination manners. The following describes the plurality of combination manners by using examples with reference to the accompanying drawings.

In some examples, the power supply connection part 10 is in contact with the first electrode contact part 8. In this case, the structure of the power supply connection part 10 and the structure of the first electrode contact part 8 are disposed in a combination manner as follows.

Optionally, as shown in FIG. 8, the power supply connection part 10 and the first electrode contact part 8 each include a single layer of film. The power supply connection part 10 is in direct contact with the first electrode contact part 8. For example, the power supply connection part 10 and the first electrode contact part 8 are of an integrated structure.

Optionally, as shown in FIG. 9, the power supply connection part 10 includes the second conductive layer 101 and the second barrier layer 102, and the first electrode contact part 8 includes the first conductive layer 81 and the first barrier layer 82. For example, the second conductive layer 101 and the first conductive layer 81 are connected to each other (or are in direct contact with each other), and are of an integrated structure. In other words, the second conductive layer 101 and the first conductive layer 81 are integrally formed, and there is no interface between the second conductive layer 101 and the first conductive layer 81. Further, for example, the second barrier layer 102 and the first barrier layer 82 are connected to each other (or are in direct contact with each other), and are of an integrated structure. In other words, the second barrier layer 102 and the first barrier layer 82 are integrally formed, and there is no interface between the second barrier layer 102 and the first barrier layer 82. Correspondingly, orthographic projections of the second barrier layer 102 and the first barrier layer 82 on the first surface B1 are closed patterns, and the second barrier layer 102 and the first barrier layer 82 jointly surround the second conductive layer 101 and the first conductive layer 81.

Optionally, the power supply connection part 10 includes a single layer of film. The first electrode contact part 8 includes the first conductive layer 81 and the first barrier layer 82, and the first barrier layer 82 is in a ring shape and surrounds the first conductive layer 81. The first electrode contact part 8 is in direct contact with the power supply connection part 10 through the first conductive layer 81.

Optionally, the power supply connection part 10 includes the second conductive layer 101 and the second barrier layer 102, and the second barrier layer 102 is in a ring shape and surrounds the second conductive layer 101. The first electrode contact part 8 includes a single layer of film. The first electrode contact part 8 is in direct contact with the second barrier layer 102 of the power supply connection part 10.

In some other examples, the power supply connection part 10 is in contact with the second electrode contact part 9. In this case, the structure of the power supply connection part 10 and the structure of the second electrode contact part 9 are disposed in a combination manner as follows.

Optionally, the power supply connection part 10 and the second electrode contact part 9 each include a single layer of film. The power supply connection part 10 is in direct contact with the second electrode contact part 9. For example, the power supply connection part 10 and the second electrode contact part 9 are of an integrated structure.

Optionally, as shown in FIG. 10, the power supply connection part 10 includes the second conductive layer 101 and the second barrier layer 102, and the second electrode contact part 9 includes the third conductive layer 91 and the third barrier layer 92. For example, the second conductive layer 101 and the third conductive layer 91 are connected to each other (or are in direct contact with each other), and are of an integrated structure. In other words, the second conductive layer 101 and the third conductive layer 91 are integrally formed, and there is no interface between the second conductive layer 101 and the third conductive layer 91. Further, for example, the second barrier layer 102 and the third conductive layer 91 are connected to each other (or are in direct contact with each other), and are of an integrated structure. In other words, the second barrier layer 102 and the third barrier layer 92 are integrally formed, and there is no interface between the second barrier layer 102 and the third barrier layer 92. Correspondingly, orthographic projections of the second barrier layer 102 and the third barrier layer 92 on the first surface B1 are closed patterns, and the second barrier layer 102 and the third barrier layer 92 jointly surround the second conductive layer 101 and the third conductive layer 91.

Optionally, the power supply connection part 10 includes a single layer of film, the second electrode contact part 9 includes the third conductive layer 91 and the third barrier layer 92, and the third barrier layer 92 is in a ring shape and surrounds the third conductive layer 91. The second electrode contact part 9 is in direct contact with the power supply connection part 10 through the third conductive layer 91.

Optionally, the power supply connection part 10 includes the second conductive layer 101 and the second barrier layer 102, and the second barrier layer 102 is in a ring shape and surrounds the second conductive layer 101. The second electrode contact part 9 includes a single layer of film. The second electrode contact part 9 is in direct contact with the second barrier layer 102 of the power supply connection part 10.

In some other examples, the power supply connection part 10 is in contact with both the first electrode contact part 8 and the second electrode contact part 9. In this case, as shown in FIG. 3 and FIG. 11, in the second direction Y, the first electrode contact part 8 and the second electrode contact part 9 are located on two opposite sides of the power supply connection part 10. Alternatively, as shown in FIG. 12, the first electrode contact part 8 and the second electrode contact part 9 are connected to each other and are of an integrated structure. The power supply connection part 10 and the isolation layer 11 are located on a side of the first electrode contact part 8 in the first direction X.

In this case, the structure of the power supply connection part 10, the structure of the first electrode contact part 8, and the structure of the second electrode contact part 9 are disposed in a plurality of combination manners. Certainly, the combination manner is not limited to the following examples.

Optionally, as shown in FIG. 3, the power supply connection part 10, the first electrode contact part 8, and the second electrode contact part 9 each include a single layer of film. The power supply connection part 10 is in direct contact and of an integrated structure with the first electrode contact part 8 and the second electrode contact part 9.

Optionally, as shown in FIG. 11, the power supply connection part 10 includes the second conductive layer 101 and the second barrier layer 102, the first electrode contact part 8 includes the first conductive layer 81 and the first barrier layer 82, and the second electrode contact part 9 includes the third conductive layer 91 and the third barrier layer 92. The first conductive layer 81, the second conductive layer 101, and the third conductive layer 91 are connected to each other (or are in direct contact with each other), and are of an integrated structure. In other words, the first conductive layer 81, the second conductive layer 101, and the third conductive layer 91 are integrally formed, and there is no interface between the first conductive layer 81, the second conductive layer 101, and the third conductive layer 91. Further, the first barrier layer 82, the second barrier layer 102, and the third barrier layer 92 are connected to each other (or are in direct contact with each other), and are of an integrated structure. Correspondingly, orthographic projections of the first barrier layer 82, the second barrier layer 102, and the third barrier layer 92 on the first surface B1 are closed patterns, and the first barrier layer 82, the second barrier layer 102, and the third barrier layer 92 jointly surround the first conductive layer 81, the second conductive layer 101, and the third conductive layer 91.

Optionally, as shown in FIG. 12, the power supply connection part 10 includes the second conductive layer 101 and the second barrier layer 102, and the second barrier layer 102 surrounds the second conductive layer 101. The first electrode contact part 8 includes the first conductive layer 81 and the first barrier layer 82, and the second electrode contact part 9 includes the third conductive layer 91 and the third barrier layer 92. The first conductive layer 81 and the third conductive layer 91 are connected to each other and are of an integrated structure, the first barrier layer 82 and the third barrier layer 92 are connected to each other and are of an integrated structure, and the first barrier layer 82 and the third barrier layer 92 jointly surround the first conductive layer 81 and the third conductive layer 91. The second barrier layer 102 of the power supply connection part 10 is in direct contact with the first barrier layer 82 and the third barrier layer 92.

Optionally, the power supply connection part 10 includes the second conductive layer 101 and the second barrier layer 102, and the second barrier layer 102 surrounds the second conductive layer 101. The first electrode contact part 8 includes the first conductive layer 81 and the first barrier layer 82, and the first barrier layer 82 surrounds the first conductive layer 81. The first electrode contact part 8 is in direct contact with the second barrier layer 102 of the power supply connection part 10 through the first barrier layer 82. The second electrode contact part 9 includes the third conductive layer 91 and the third barrier layer 92, and the third barrier layer 92 surrounds the third conductive layer 91. The second electrode contact part 9 is in direct contact with the second barrier layer 102 of the power supply connection part 10 through the third barrier layer 92.

Certainly, at least one of the power supply connection part 10, the first electrode contact part 8, and the second electrode contact part 9 may include a single layer of film, or may be formed by stacking a plurality of film layers. For details, refer to the foregoing related description in which the power supply connection part 10 is in contact with the first electrode contact part 8 and the power supply connection part 10 is in contact with the second electrode contact part 9. Details are not described herein again.

In some embodiments, with reference to FIG. 3 and FIG. 7, the integrated circuit 600 provided in this embodiment of this application further includes a third electrode contact part 12, a fourth electrode contact part 13, and an interconnection layer 14.

As shown in FIG. 3 and FIG. 7, the third electrode contact part 12 and the fourth electrode contact part 13 are respectively located on two opposite sides of the power supply connection part 10 in the second direction Y. The isolation layer 11 further isolates the power supply contact part 10 from the third electrode contact part 12, and isolates the power supply contact part 10 from the fourth electrode contact part 13. For example, in FIG. 3, in the second direction Y, the third electrode contact part 12 is located on an upper side of the power supply connection part 10, and the fourth electrode contact part 13 is located on a lower side of the power supply connection part 10.

The third electrode contact part 12 and the fourth electrode contact part 13 are located on different second electrodes 5, and are in contact with the corresponding second electrodes 5.

For example, with reference to FIG. 3 and FIG. 7, the third electrode contact part 12 penetrates the second dielectric layer 6 to the second electrode 5 located on the upper side of the power supply connection part 10. The third electrode contact part 12 is in contact with (for example, in direct contact with) the second electrode 5. There may be a plurality of second electrodes 5 in contact with a same third electrode contact part 12, and a specific quantity may be specifically set according to an actual product requirement. For example, in FIG. 7, there are two second electrodes 5 in contact with a same third electrode contact part 12.

The third electrode contact part 12 extends in the second direction Y. In the first direction X, the third electrode contact part 12 and the first electrode contact part 8 are located on two opposite sides of the gate line 3.

For example, with reference to FIG. 3 and FIG. 7, the fourth electrode contact part 13 penetrates the second dielectric layer 6 to the second electrode 5 located on the lower side of the power supply connection part 10. The fourth electrode contact part 13 is in contact with (for example, in direct contact with) the second electrode 5. There may be a plurality of second electrodes 5 in contact with a same fourth electrode contact part 13, and a specific quantity may be specifically set according to an actual product requirement. For example, in FIG. 7, there are two second electrodes 5 in contact with a same fourth electrode contact part 13.

The fourth electrode contact part 13 extends in the second direction Y. In the first direction X, the fourth electrode contact part 13 and the second electrode contact part 9 are located on two opposite sides of the gate line 3.

The interconnection layer 14 includes a plurality of fifth dielectric layers that are spaced apart in the third direction Z, and a second metal routing layer located between two adjacent fifth dielectric layers. Metal traces in different second metal routing layers may be connected by using vias in the fifth dielectric layer. As shown in FIG. 7, the interconnection layer 14 is located on the third electrode contact part 12 and the fourth electrode contact part 13, and a metal trace in the interconnection layer 14 is electrically connected to the third electrode contact part 12 and the fourth electrode contact part 13. The third electrode contact part 12 and the fourth electrode contact part 13 can receive an electrical signal from the interconnection layer 14.

The interconnection layer 14 can be disposed to implement interconnection between elements (such as a transistor, a capacitor, and a resistor) on the power delivery network 7.

The third electrode contact part 12 has a plurality of structures that may be set depending on an actual requirement.

In some examples, as shown in FIG. 3, the third electrode contact part 12 includes a single layer of film. In this case, a material of the third electrode contact part 12 includes a conductive material. For example, the conductive material includes but is not limited to one or more of aluminum, copper, tungsten, molybdenum, cobalt, and the like.

In some other examples, as shown in FIG. 9, the third electrode contact part 12 is formed by stacking a plurality of film layers. For example, the third electrode contact part 12 includes a fourth conductive layer and a fourth barrier layer. The fourth barrier layer is disposed around the fourth conductive layer. In this case, a material of the fourth conductive layer includes a conductive material. For example, the conductive material includes but is not limited to one or more of aluminum, copper, tungsten, molybdenum, cobalt, and the like. A material of the fourth barrier layer includes but is not limited to one or more of titanium, titanium nitride, tantalum, tantalum nitride, and the like.

The fourth electrode contact part 13 has a plurality of structures that may be set depending on an actual requirement.

In some examples, as shown in FIG. 3, the fourth electrode contact part 13 includes a single layer of film. In this case, a material of the fourth electrode contact part 13 includes a conductive material. For example, the conductive material includes but is not limited to one or more of aluminum, copper, tungsten, molybdenum, cobalt, and the like.

In some other examples, as shown in FIG. 9, the fourth electrode contact part 13 is formed by stacking a plurality of film layers. For example, the fourth electrode contact part 13 includes a fifth conductive layer and a fifth barrier layer. The fifth barrier layer is disposed around the fifth conductive layer. In this case, a material of the fifth conductive layer includes a conductive material. For example, the conductive material includes but is not limited to one or more of aluminum, copper, tungsten, molybdenum, cobalt, and the like. A material of the fifth barrier layer includes but is not limited to one or more of titanium, titanium nitride, tantalum, tantalum nitride, and the like.

The structure of the third electrode contact part 12 may be the same as or different from the structure of the fourth electrode contact part 13. The material of the third electrode contact part 12 may be the same as or different from the material of the fourth electrode contact part 13.

Further, the structure of either the third electrode contact part 12 or the fourth electrode contact part 13 may be the same as or different from the structure of either the first electrode contact part 8 or the second electrode contact part 9. The material of either the third electrode contact part 12 or the fourth electrode contact part 13 may be the same as or different from the material of either the first electrode contact part 8 or the second electrode contact part 9.

In some examples, as shown in FIG. 3 and FIG. 9, the third electrode contact part 12, the fourth electrode contact part 13, and the power supply connection part 10 are disposed at a same layer.

In other words, the third electrode contact part 12, the fourth electrode contact part 13, and the power supply connection part 10 are formed by performing patterning on a same film. Correspondingly, the third electrode contact part 12, the fourth electrode contact part 13, and the power supply connection part 10 have a same material and a same structure. In this way, the third electrode contact part 12 and the power supply connection part 10 can be formed synchronously in a same patterning process, thereby helping simplify a preparation process for the integrated circuit 600.

Further, the first electrode contact part 8, the second electrode contact part 9, the third electrode contact part 12, the fourth electrode contact part 13, and the power supply connection part 10 are disposed at a same layer.

In some embodiments, as shown in FIG. 3, the integrated circuit 600 provided in this embodiment of this application further includes at least two dummy gate lines 15. The dummy gate line 15 is located on the first dielectric layer 2 and is disposed across a plurality of semiconductor structures 1. A quantity of semiconductor structures 1 across which the dummy gate line 15 is disposed may be the same as or different from a quantity of semiconductor structures 1 across which the gate line 3 is disposed.

For example, the at least two dummy gate lines 15 extend in the second direction Y, and are spaced apart in the first direction X. In the at least two dummy gate lines 15, at least two gate lines 3 are disposed between two adjacent dummy gate lines 15, and the at least two gate lines 3 are divided by the power supply connection part 10. Further, as shown in FIG. 3, the power supply connection part 10 further divides the dummy gate line 15.

Optionally, the dummy gate line 15 and the gate line 3 are made of a same material. For example, the dummy gate line 15 is located in a dummy region that does not form a logic circuit. A transistor located in the dummy region may be referred to as a dummy transistor, and does not transmit an electrical signal. For example, the dummy gate line 15 is configured to isolate two adjacent standard units (or logic units).

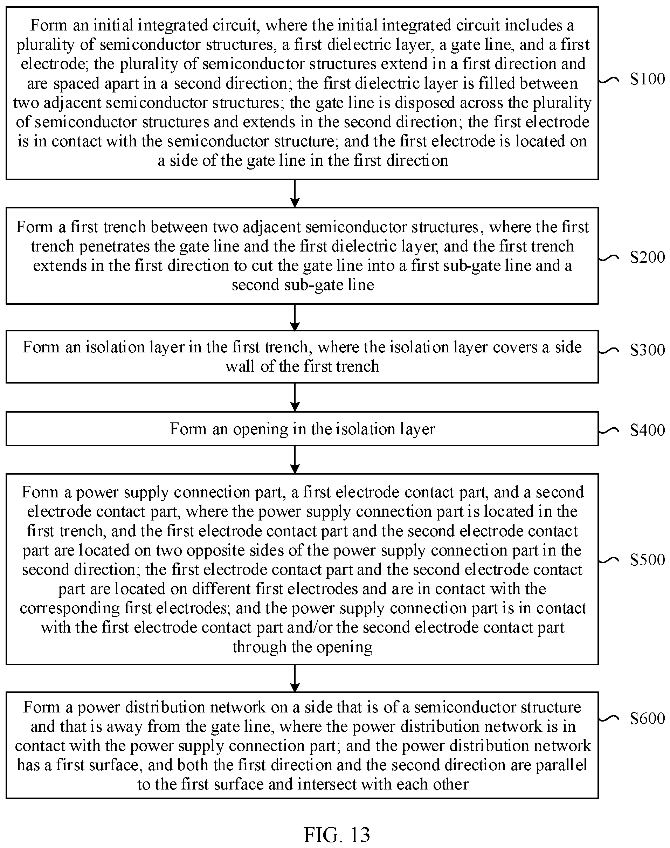

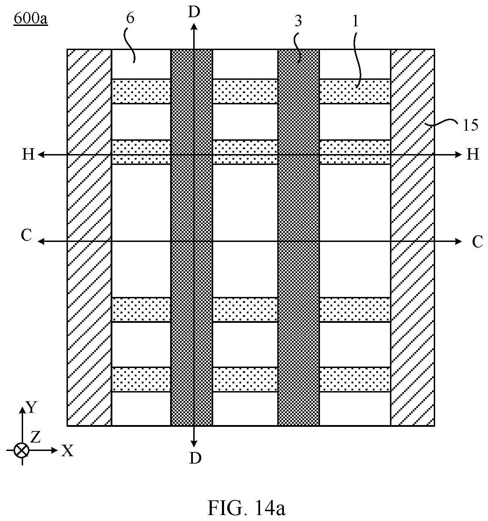

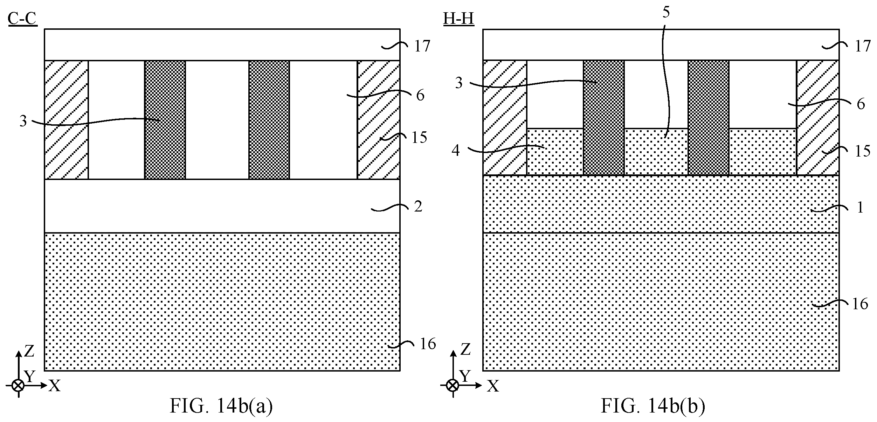

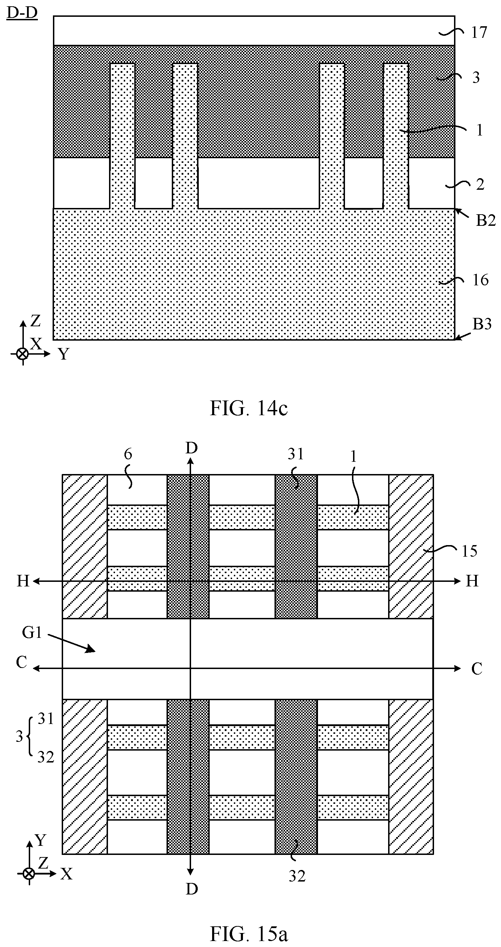

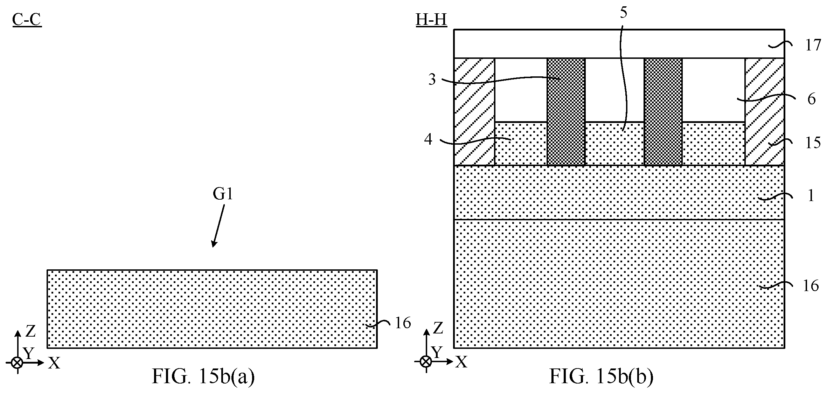

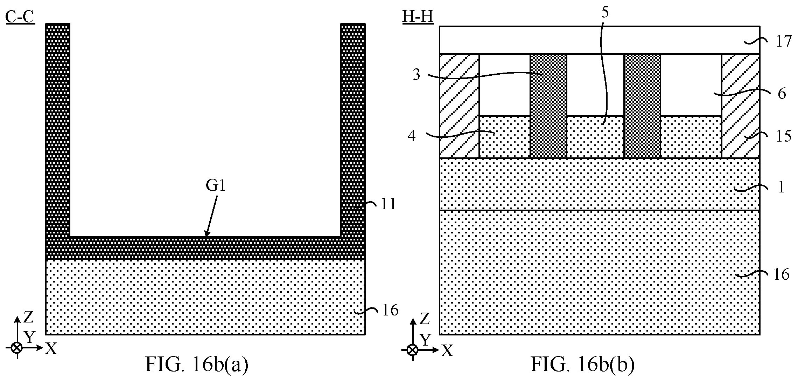

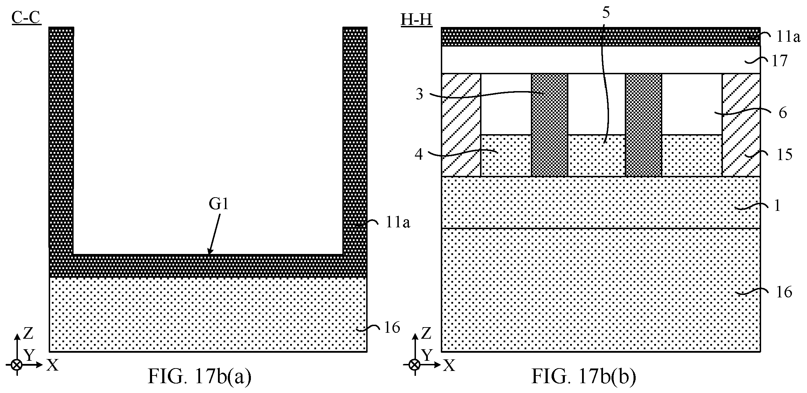

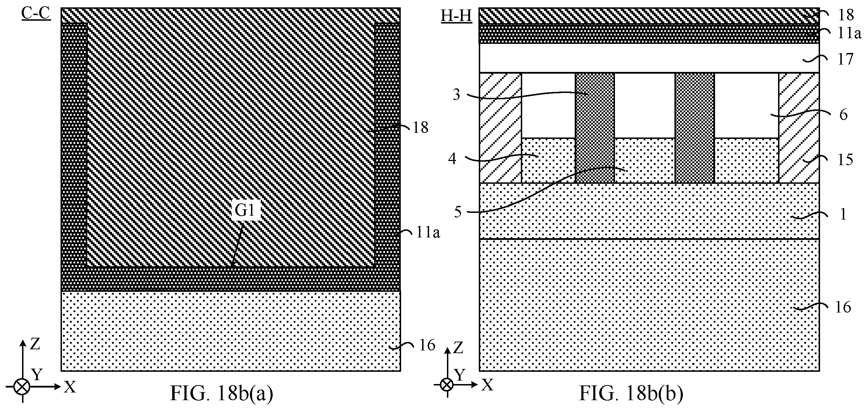

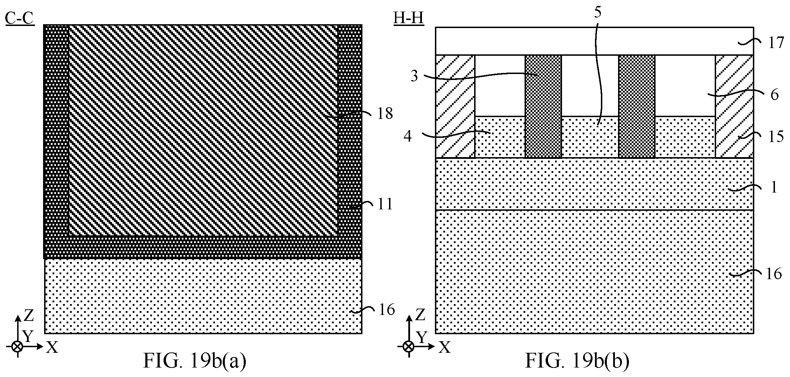

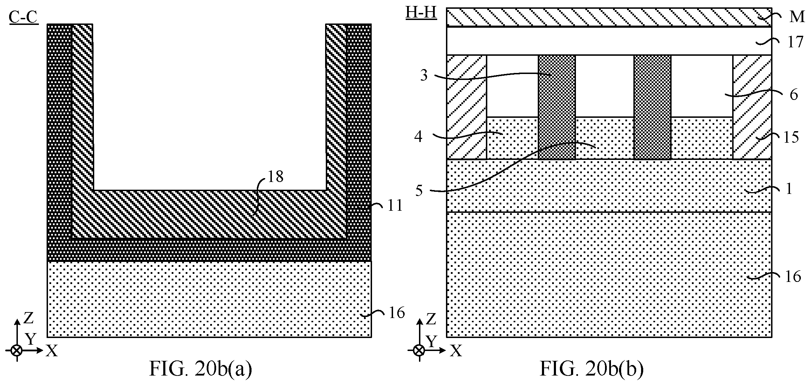

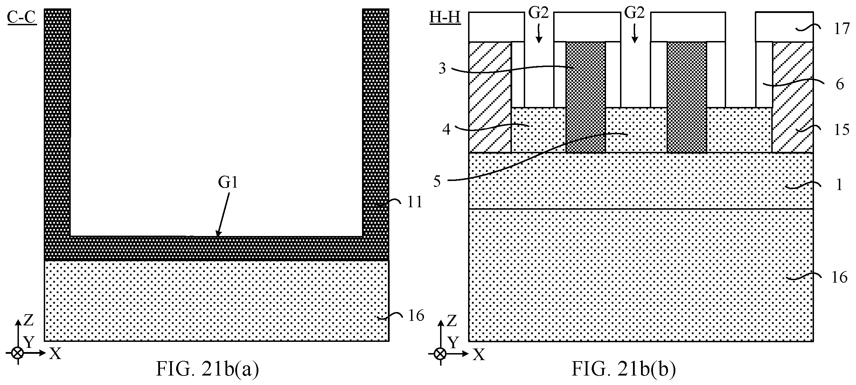

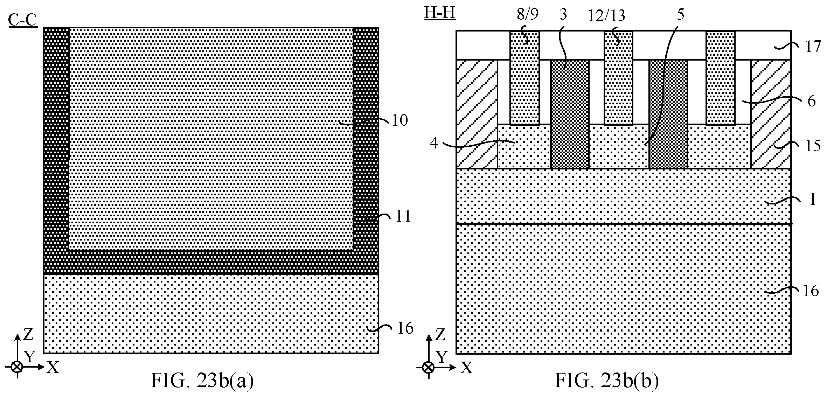

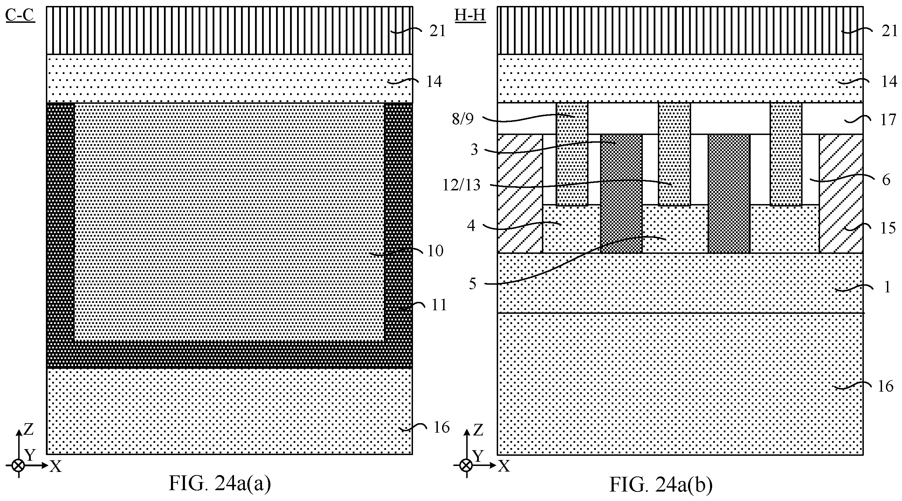

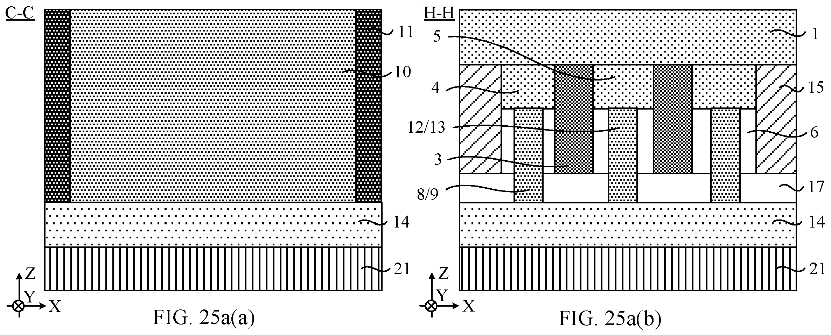

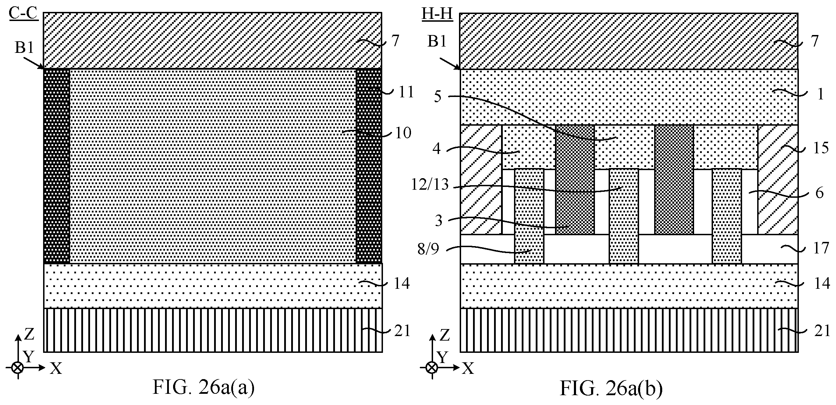

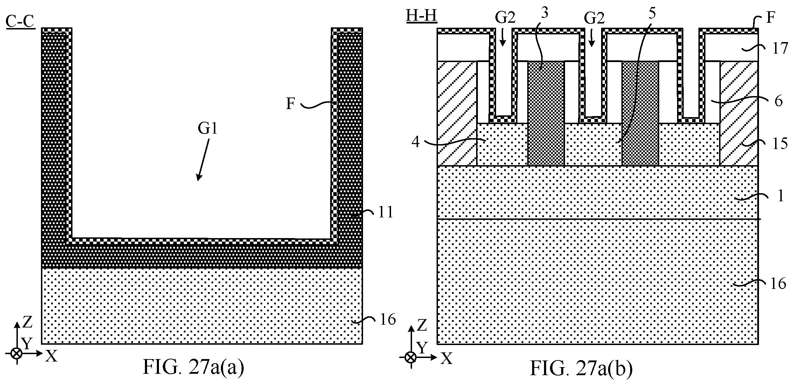

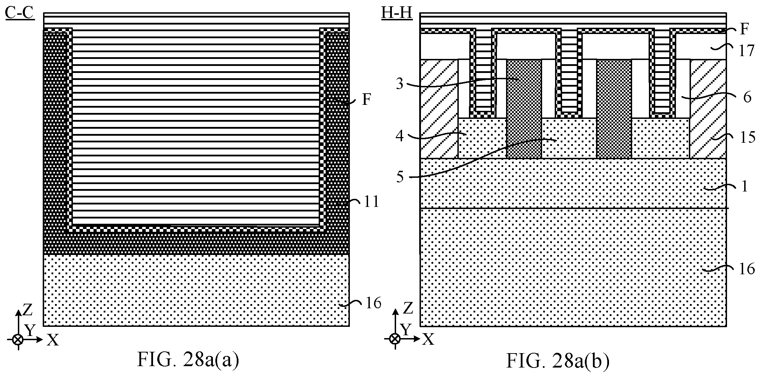

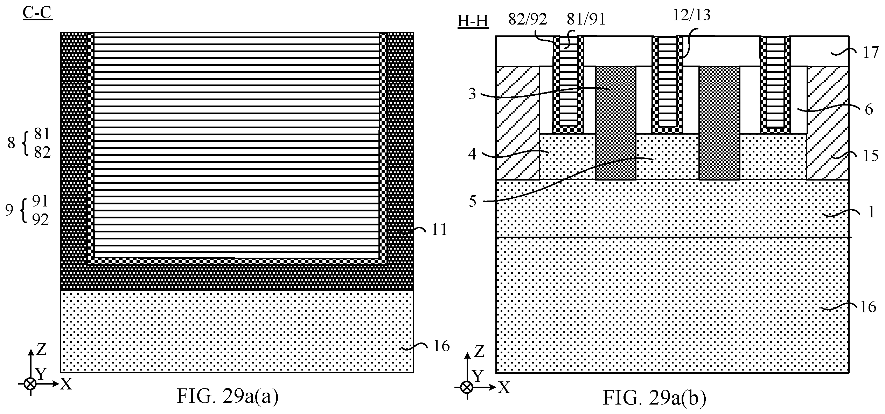

Some embodiments of this application further provide a preparation method for an integrated circuit. For example, the preparation method is used to prepare and form the integrated circuit 600 according to any one of the foregoing examples. FIG. 13 is a flowchart of a preparation method for an integrated circuit. FIG. 14a to FIG. 29b show structures corresponding to steps in the preparation method for the integrated circuit. Herein, FIG. 14b(a) and FIG. 14b(b), FIG. 15b(a) and FIG. 15b(b), FIG. 16b(a) and FIG. 16b(b), FIG. 17b(a) and FIG. 17b(b), FIG. 18b(a) and FIG. 18b(b), FIG. 19b(a) and FIG. 19b(b), FIG. 20b(a) and FIG. 20b(b), FIG. 21b(a) and FIG. 21b(b), FIG. 23b(a) and FIG. 23b(b), FIG. 24a(a) and FIG. 24a(b), FIG. 25a(a) and FIG. 25a(b), FIG. 26a(a) and FIG. 26a(b), FIG. 27a(a) and FIG. 27a(b), FIG. 28a(a) and FIG. 28a(b), and FIG. 29a(a) and FIG. 29a(b) respectively represent cross-sectional structures of a structure formed in a corresponding step in a C-C direction and an H-H direction. FIG. 14c, FIG. 15c, FIG. 16c, FIG. 17c, FIG. 18c, FIG. 19c, FIG. 20c, FIG. 23c, FIG. 24b, FIG. 25b, FIG. 26b, FIG. 27b, FIG. 28b, and FIG. 29b each represent a cross-sectional structure of a structure formed in a corresponding step in a D-D direction. It should be understood that the steps shown in FIG. 13 are not exclusive, and another step may be further performed before, after, or between any steps in the steps shown in FIG. 13. In addition, some of the steps may be performed simultaneously, or may be performed in a sequence different from that shown in FIG. 13.

With reference to accompanying drawings, the following schematically describes the preparation method for the integrated circuit. As shown in FIG. 13, the preparation method includes S100 to S600.

S100: Form an initial integrated circuit 600a, as shown in FIG. 14a, FIG. 14b(a) and FIG. 14b(b), and FIG. 14c. The initial integrated circuit 600a includes a plurality of semiconductor structures 1, a first dielectric layer 2, a gate line 3, and a first electrode 4. The plurality of semiconductor structures 1 extend in a first direction X and are spaced apart in a second direction Y. The first dielectric layer 2 is filled between two adjacent semiconductor structures 1. The gate line 3 is disposed across the plurality of semiconductor structures 1 and extends in the second direction Y. The first electrode 4 is in contact with the semiconductor structure 1. In the first direction X, the first electrode 4 is located on a side of the gate line 3. Optionally, the first dielectric layer 2 may alternatively cover the semiconductor structure 1.

For example, as shown in FIG. 14b(a) and FIG. 14b(b) and FIG. 14c, the initial integrated circuit 600a further includes a substrate 16, a second electrode 5, a second dielectric layer 6, and a sixth dielectric layer 17.

As shown in FIG. 14c, the substrate 16 has a second surface B2 and a third surface B3 that are opposite to each other, and the semiconductor structure 1 and the first dielectric layer 2 are located on the second surface B2. The gate line 3 and the first electrode 4 are located on a side that is of the semiconductor structure 1 and that is away from the substrate 16. The substrate 16 is configured to provide support for subsequent preparation process steps. Optionally, a material of the substrate 16 includes a semiconductor material. The semiconductor material includes but is not limited to silicon (Si), germanium, silicon-germanium, silicon carbide, silicon-on-insulator, silicon-germanium-on-insulator, other III-V materials, or the like.

The second electrode 5 is in contact with the semiconductor structure 1. In the first direction X, the second electrode 5 and the first electrode 4 are located on two opposite sides of the gate line 3. The second dielectric layer 6 is located on the first dielectric layer 2, is disposed across the plurality of semiconductor structures 1, and covers the first electrode 4 and the second electrode 5. There are a plurality of second dielectric layers 6. For example, the plurality of second dielectric layers 6 extend in the second direction Y and are spaced apart in the first direction X. In the first direction X, the second dielectric layer 6 is located on two opposite sides of the gate line 3. In this way, it is convenient to isolate adjacent gate lines 3 by using the second dielectric layer 6. The sixth dielectric layer 17 covers the gate line 3 and the second dielectric layer 6, to protect the gate line 3 and the second dielectric layer 6 in a subsequent preparation process step.

For how the semiconductor structure 1 is disposed, and how the first electrode 4, the second electrode 5, and the semiconductor structure 1 are disposed, refer to the foregoing related descriptions. Details are not described herein again.

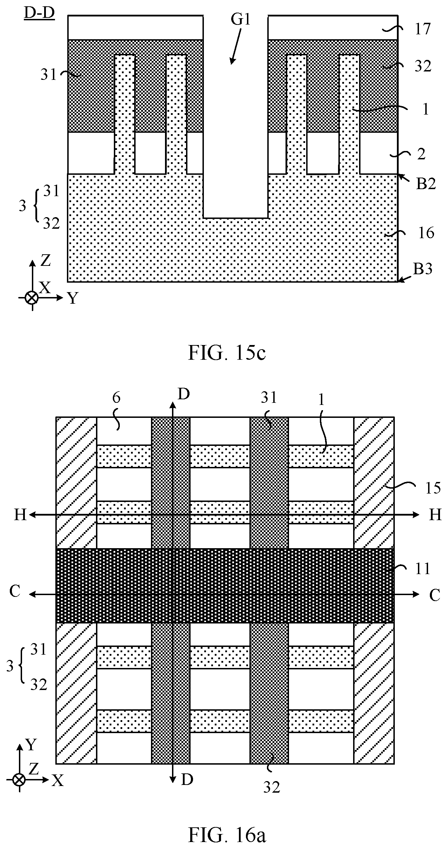

S200: Form a first trench G1 between two adjacent semiconductor structures 1, as shown in FIG. 15a, FIG. 15b(a) and FIG. 15b(b), and FIG. 15c. The first trench G1 penetrates the gate line 3 and the first dielectric layer 2. The first trench G1 extends in the first direction X, and the gate line 3 is cut into a first sub-gate line 31 and a second sub-gate line 32.

For example, in this embodiment of this application, a portion of the sixth dielectric layer 17, the gate line 3, and the first dielectric layer 2 that are between the two adjacent semiconductor structures 1 may be etched by using a photolithography process, to form the first trench G1. In the first direction X, the first trench G1 is bar-shaped, and a plurality of gate lines 3 can be cut off by the first trench G1. There may be two, three, four, or even more gate lines 3 cut off by the first trench G1. For example, in FIG. 15a, two gate lines 3 are cut off by the first trench G1.

Further, as shown in FIG. 15a, the second dielectric layer 6 adjacent to the gate line 3 is further cut off by the first trench G1. Certainly, the first trench G1 may alternatively extend only into the second dielectric layer 6 (for example, the leftmost second dielectric layer 6 in FIG. 15a) adjacent to the gate line 3, and the second dielectric layer 6 is not cut off.

Optionally, in a third direction Z, the first trench G1 may extend to the second surface B2 of the substrate 16, or as shown in FIG. 15b(a) and FIG. 15c, the first trench G1 may extend into the substrate 16. This helps improve performance of the integrated circuit formed through preparation.

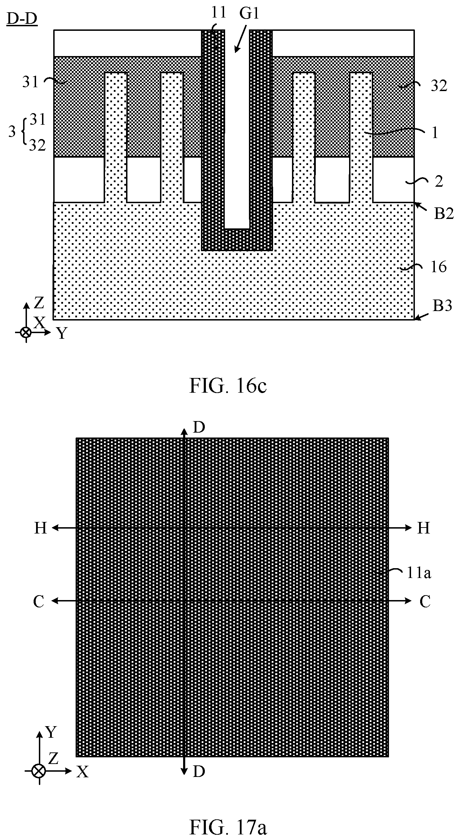

S300: Form an isolation layer 11 in the first trench G1, as shown in FIG. 16a, FIG. 16b(a) and FIG. 16b(b), and FIG. 16c. The isolation layer 11 covers a side wall of the first trench G1. Correspondingly, the isolation layer 11 is in contact with the first sub-gate line 31 and the second sub-gate line 32.

Optionally, the isolation layer 11 further covers a bottom wall of the first trench G1. The first trench G1 is not filled up with the isolation layer 11, and space is reserved for a power supply connection part 10. For example, in FIG. 16c, a portion that is of the isolation layer 11 and that is located in the first trench G1 is U-shaped. Compared with the second surface B2, a portion that is of the isolation layer 11 and that covers the first trench G1 is lower than a surface on a side that is of the gate line 3 and that is close to the substrate 16.

For example, a method for forming the isolation layer 11 in the first trench G1 includes S310 to S330.

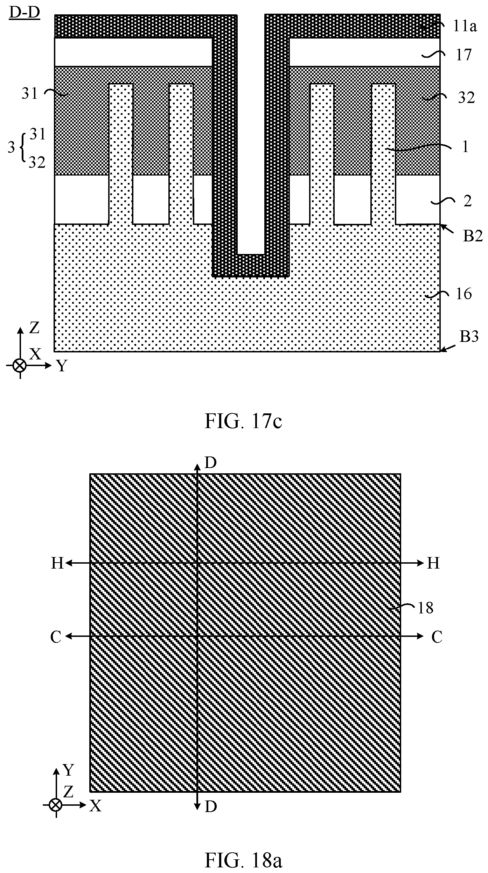

S310: Form an isolation film 11a, as shown in FIG. 17a, FIG. 17b(a) and FIG. 17b(b), and FIG. 17c. The isolation film 11a covers the gate line 3, and the side wall and the bottom wall that are of the first trench G1.

For example, in this embodiment of this application, the isolation film 11a may be formed by using a deposition process. A material of the isolation film 11a includes but is not limited to at least one of silicon nitride, silicon carbide, silicon carbonitride, or silicon oxynitride. Optionally, the deposition process includes but is not limited to an atomic layer deposition process, and the isolation film 11a formed by using the atomic layer deposition process has a uniform thickness.

Specifically, the isolation film 11a is in contact with the first sub-gate line 31 and the second sub-gate line 32, and the sixth dielectric layer 17 is disposed between the isolation film 11a and the gate line 3.

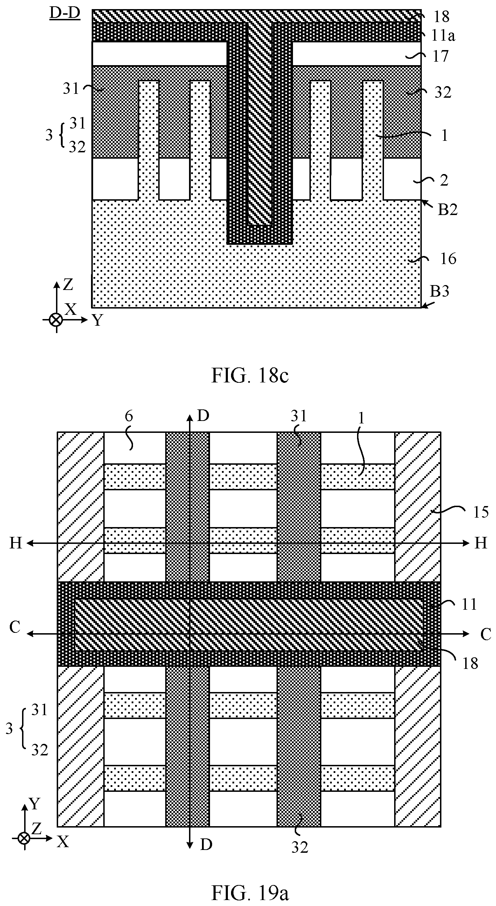

S320: Form a third dielectric layer 18, as shown in FIG. 18a, FIG. 18b(a) and FIG. 18b(b), and FIG. 18c. A portion of the third dielectric layer 18 is filled in the first trench G1, and another portion of the third dielectric layer 18 is located on a side that is of the isolation film 11a and that is away from the gate line 3.

For example, in this embodiment of this application, the third dielectric layer 18 may be formed by using the deposition process. The deposition process includes but is not limited to a film deposition process of flowable chemical vapor deposition (flowable CVD, FCVD), chemical vapor deposition, physical vapor deposition, atomic layer deposition, or any combination thereof. The third dielectric layer 18 fills up a region defined by the isolation film 11a in the first trench G1, and covers the isolation film 11a. A material of the third dielectric layer 18 includes but is not limited to silicon oxide, or the like.

The material of the third dielectric layer 18 is different from the material of the isolation film 11a. In this way, there may be different etching selection ratios between the third dielectric layer 18 and the isolation film 11a, so that the third dielectric layer 18 can be removed subsequently.

S330: Synchronously remove portions that are of the third dielectric layer 18 and the isolation film 11a and that are located on the gate line 3, and etch a portion that is of the third dielectric layer 18 and that is filled in the first trench G1, as shown in FIG. 19a to FIG. 20c.

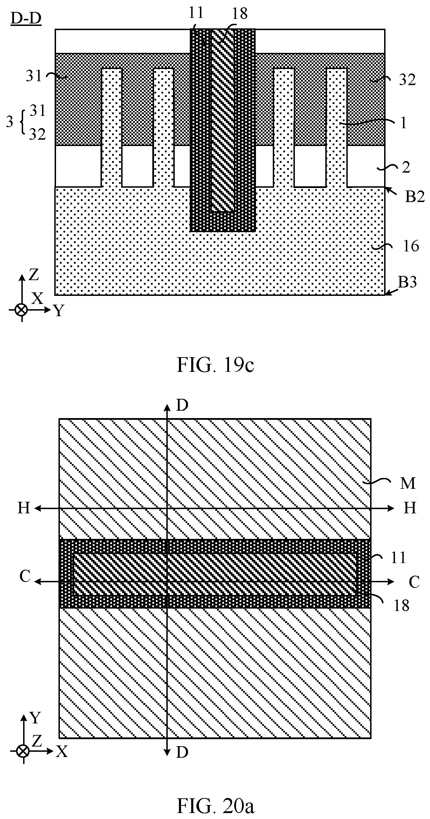

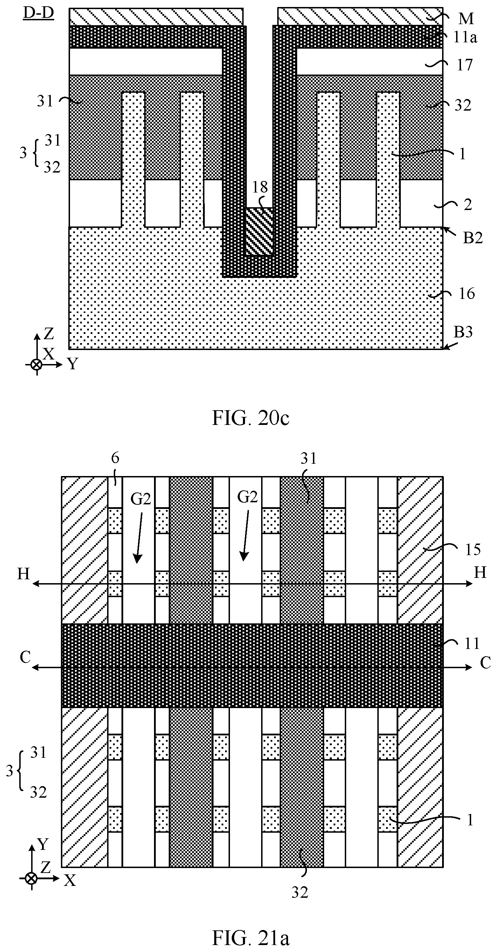

For example, as shown in FIG. 19a, FIG. 19b(a) and FIG. 19b(b), and FIG. 19c, in this embodiment of this application, portions that are of the third dielectric layer 18 and the isolation film 11a and that are covered on the sixth dielectric layer 17 may be first polished and removed by using a chemical mechanical polishing (chemical mechanical polishing, CMP) process. Then, as shown in FIG. 20a, FIG. 20b(a) and FIG. 20b(b), and FIG. 20c, a mask layer M is formed on the sixth dielectric layer 17. The portion that is of the third dielectric layer 18 and that is filled in the first trench G1 is exposed from the mask layer M. Then, the portion that is of the third dielectric layer 18 and that is filled in the first trench G1 is removed through etching based on the mask layer M.

The portion that is of the third dielectric layer 18 and that is located in the first trench G1 may be completely removed (as shown in FIG. 17b(a) and FIG. 17c), or may be partially removed (as shown in FIG. 20b(a) and FIG. 20c). When only a part is removed, a surface on a side that is of a remaining portion of the third dielectric layer 18 and that is away from the substrate 16 may be lower than the second surface B2 of the substrate 16, or may be located between the second surface B2 and the surface on the side that is of the gate line 3 and that is close to the substrate 16 (as shown in FIG. 20c), to ensure that the surface on the side that is of the remaining portion of the third dielectric layer 18 and that is away from the substrate 16 is lower than the surface on the side that is of the gate line 3 and that is close to the substrate 16.

Optionally, before the portion that is of the third dielectric layer 18 and that is filled in the first trench G1 is etched, the portions that are of the third dielectric layer 18 and the isolation film 11a and that are covered on the sixth dielectric layer 17 may not be removed, or only a portion that is of the third dielectric layer 18 and that is covered on the isolation film 11a may be removed.

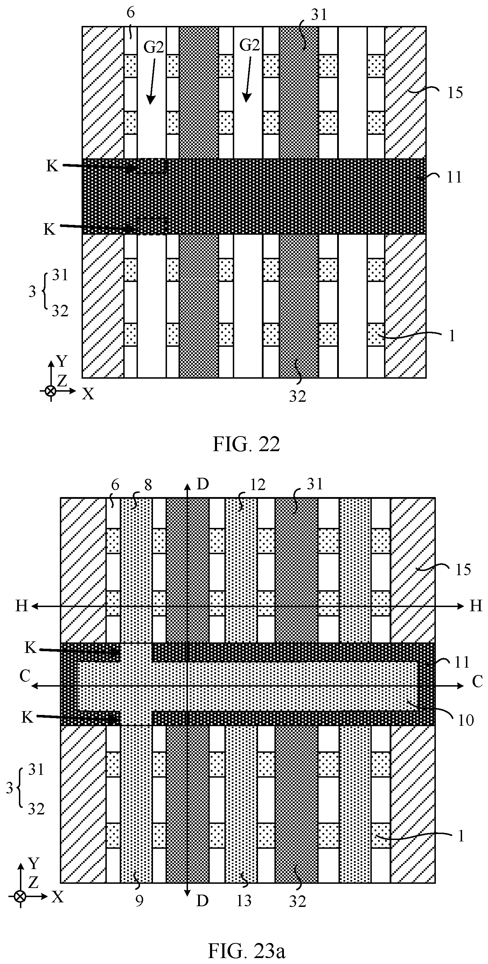

S400: Form an opening K in the isolation layer 11, as shown in FIG. 22.

For example, in this embodiment of this application, the isolation layer 11 may be etched by using the photolithography process, to form the opening K.

Positions and a quantity of openings K are related to a connection relationship among a to-be-formed power supply connection part 10, the first electrode contact part 8, and the second electrode contact part 9. For example, when the power supply connection part 10 is in contact with the first electrode contact part 8, a portion that is of the isolation layer 11 and that is located between the power supply connection part 10 and the first electrode contact part 8 may be removed through etching to form an opening K, so that a subsequently-formed power supply connection part 10 may be in contact with the first electrode contact part 8 through the opening K. For another example, when the power supply connection part 10 is in contact with the second electrode contact part 9, a portion that is of the isolation layer 11 and that is located between the power supply connection part 10 and the second electrode contact part 9 may be removed through etching to form an opening K, so that a subsequently-formed power supply connection part 10 may be in contact with the second electrode contact part 9 through the opening K. For another example, as shown in FIG. 22, when the power supply connection part 10 is in contact with both the first electrode contact part 8 and the second electrode contact part 9, two openings K may be formed in the isolation layer 11 through etching. One of the openings K is located between the power supply connection part 10 and the first electrode contact part 8, so that a subsequently-formed power supply connection part 10 may be in contact with the first electrode contact part 8 through the opening K. The other opening K is located between the power supply connection part 10 and the second electrode contact part 9, so that the subsequently formed power supply connection part 10 may be in contact with the second electrode contact part 9 through the opening K. Certainly, when the power supply connection part 10 is in contact with both the first electrode contact part 8 and the second electrode contact part 9, one opening K may alternatively be formed in the isolation layer 11 through etching, and a subsequently-formed power supply connection part 10 may be in contact with both the first electrode contact part 8 and the second electrode contact part 9 through the opening K.

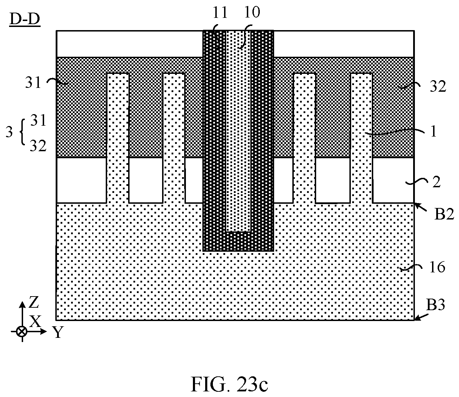

S500: Form the power supply connection part 10, the first electrode contact part 8, and the second electrode contact part 9, as shown in FIG. 23a, FIG. 23b(a) and FIG. 23b(b), and FIG. 23c. The power supply connection part 10 is located in the first trench G1, and the first electrode contact part 8 and the second electrode contact part 9 are located on two opposite sides of the power supply connection part 10 in the second direction Y. The first electrode contact part 8 and the second electrode contact part 9 are located on different first electrodes 4, and are in contact with the corresponding first electrodes 4. The power supply connection part 10 is in contact with the first electrode contact part 8 and/or the second electrode contact part 9 through the opening K.

For example, in this embodiment of this application, the power supply connection part 10, the first electrode contact part 8, and the second electrode contact part 9 may be formed by using a metal filling process, a chemical mechanical polishing process, or the like. In a process of filling the first trench G1 with a required material to form the power supply connection part 10, the isolation layer 11 can provide a self-alignment effect, so that the required material may be naturally filled in a region defined by the isolation layer 11 and the opening K of the isolation layer 11, and be in contact with the first electrode contact part 8 and/or the second electrode contact part 9.

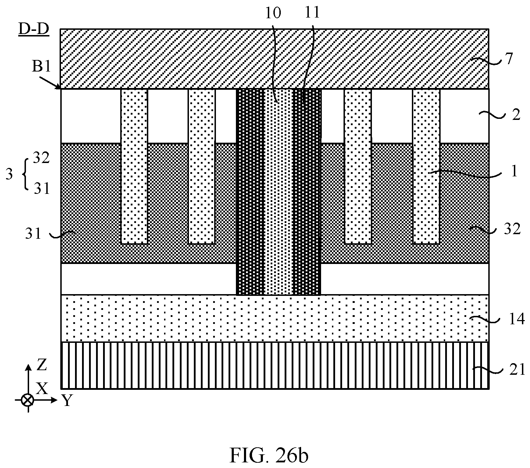

S600: Form a power delivery network 7 on a side that is of the semiconductor structure 1 and that is away from the gate line 3, as shown in FIG. 26a(a) and FIG. 26a(b) and FIG. 26b. The power delivery network 7 is in contact with the power supply connection part 10. The power delivery network 7 has a first surface B1, and both the first direction X and the second direction Y are parallel to the first surface B1, and intersect with each other.

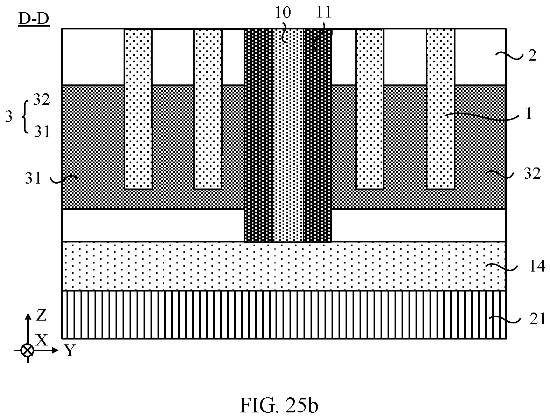

For example, when the initial integrated circuit 600a further includes the substrate 16, as shown in FIG. 25a(a) and FIG. 25a(b) and FIG. 25b, before the power delivery network 7 is formed on the side that is of the semiconductor structure 1 and that is away from the gate line 3, the preparation method further includes: removing the substrate 16 from a side on which the third surface B3 is located, to expose the power supply connection part 10. In this way, it can be ensured that, in the prepared integrated circuit 600, an end that is of the power supply connection part 10 and that is close to the power delivery network 7 is located in the first dielectric layer 2, thereby helping improve performance of the integrated circuit 600 formed through preparation.

For example, as shown in FIG. 25a(a) and FIG. 25a(b) and FIG. 25b, a method for removing the substrate 16 from the side on which the third surface B3 is located includes: flipping the initial integrated circuit 600a, and then polishing and removing the substrate 16 by using the chemical mechanical polishing process. In the process of polishing and removing the substrate 16, a portion that is of the isolation layer 11 and that further covers the bottom wall of the first trench G1 is further removed, so that the power supply connection part 10 is in contact with the power delivery network 7, to form an electrical connection.

According to the preparation method for an integrated circuit provided in this embodiment of this application, the isolation layer 11 is formed in the first trench G1 formed between two adjacent semiconductor structures 1, to provide a self-alignment effect for the power supply connection part 10 subsequently formed in the first trench G1, so that a material of the power supply connection part 10 is naturally filled in a region defined by the isolation layer 11. Difficulty in required processes such as alignment, photolithography, and etching is low, thereby helping increase a process window.

In addition, in comparison with the foregoing possible implementation, in this embodiment of this application, there is no need to etch the isolation layer 11 to form a power via, thereby avoiding a problem caused by etching the power via. In other words, in this embodiment of this application, by using the isolation layer 11 with a uniform thickness, the power supply connection part 10 may be electrically insulated from the first sub-gate line 31, and the power supply connection part 10 may be electrically insulated from the second sub-gate line 32. In addition, there may be a sufficient insulation distance between the power supply connection part 10 and the first sub-gate line 31, and a sufficient insulation distance between the power supply connection part 10 and the second sub-gate line 32. This can reduce a risk of short circuit or breakdown between the power supply connection part 10 and the first sub-gate line 31, and between the power supply connection part 10 and the second sub-gate line 32, and increase a breakdown voltage between the power supply connection part 10 and the first sub-gate line 31, and between the power supply connection part 10 and the second sub-gate line 32, thereby improving reliability of the integrated circuit 600.

It may be understood that, in S500, there are a plurality of methods for forming the power supply connection part 10, the first electrode contact part 8, and the second electrode contact part 9. For example, in this embodiment of this application, the power supply connection part 10 may be first formed in the first trench G1 and the opening K, and then the first electrode contact part 8 and the second electrode contact part 9 are formed on a side of the gate line 3, so that the power supply connection part 10 is in contact with the first electrode contact part 8 and/or the second electrode contact part 9 through the opening K. For another example, in this embodiment of this application, the first electrode contact part 8 and the second electrode contact part 9 may be first formed on a side of the gate line 3, and then the power supply connection part 10 is formed in the first trench G1 and the opening K, so that the power supply connection part 10 is in contact with the first electrode contact part 8 and/or the second electrode contact part 9 through the opening K. For another example, in this embodiment of this application, the power supply connection part 10, the first electrode contact part 8, and the second electrode contact part 9 may be synchronously formed in a same patterning process.

In a same patterning process, the power supply connection part 10, the first electrode contact part 8, and the second electrode contact part 9 are formed synchronously, thereby helping simplify a preparation process for the integrated circuit. With reference to the accompanying drawings, the following schematically describes a preparation method for the power supply connection part 10, the first electrode contact part 8, and the second electrode contact part 9 by using the accompanying drawings as an example.

In some examples, as shown in FIG. 21a and FIG. 21b(a) and FIG. 21b(b), before S400, that is, before forming the opening K in the isolation layer 11, the preparation method further includes: forming a second trench G2 in the second dielectric layer 6. The first electrode 4 is exposed from the second trench G2, and in the second direction Y, the second trench G2 is located on two opposite sides of the isolation layer 11. The second trench G2 communicates with the first trench G1 through the opening K.

For example, in this embodiment of this application, the second dielectric layer 6 may be etched by using the photolithography process, to form the second trench G2 in the second dielectric layer 6. In the third direction Z, the second trench G2 penetrates the sixth dielectric layer 17 and extends into the second dielectric layer 6, or extends into the first dielectric layer 2, provided that the first electrode 4 can be exposed. In the first direction X, there is a spacing between the second trench G2 and the gate line 3, so that there is a dielectric material between the second trench G2 and the gate line 3, to ensure electrical insulation between the first electrode contact part 8 and the gate line 3 and electrical insulation between the second electrode contact part 9 and the gate line 3 that are subsequently formed.

After the second trench G2 is formed, the opening K may be formed in the isolation layer 11. When the power supply connection part 10 is in contact with the first electrode contact part 8, the opening K may communicate with the first trench G1 and the second trench G2 located above the isolation layer 11 in the second direction Y. Alternatively, when the power supply connection part 10 is in contact with the second electrode contact part 9, the opening K may communicate with the first trench G1 and the second trench G2 located below the isolation layer 11 in the second direction Y. Alternatively, as shown in FIG. 22, when the power supply connection part 10 is in contact with both the first electrode contact part 8 and the second electrode contact part 9, the opening K may communicate with both the first trench G1 and the second trench G2 located above and below the isolation layer 11 in the second direction Y.

In some examples, as shown in FIG. 23a, FIG. 23b(a) and FIG. 23b(b), and FIG. 23c, in S500, a method for forming the power supply connection part 10, the first electrode contact part 8, and the second electrode contact part 9 includes: filling the first trench G1, the second trench G2, and the opening K with a conductive material, to form the power supply connection part 10, the first electrode contact part 8, and the second electrode contact part 9.

Optionally, the conductive material includes but is not limited to one or more of aluminum, copper, tungsten, molybdenum, cobalt, and the like. In this embodiment of this application, the metal filling process may be used to fill the first trench G1, the second trench G2, and the opening K with a conductive material, and fill up the first trench G1, the second trench G2, and the opening K with the conductive material. The conductive material is further located on the sixth dielectric layer 17. Then, the chemical mechanical polishing process may be used to polish and remove a portion of the conductive material located on the sixth dielectric layer 17, and retain a portion of the conductive material located in the first trench G1, the second trench G2, and the opening K, to obtain the power supply connection part 10, the first electrode contact part 8, and the second electrode contact part 9. The power supply connection part 10 is further located in the region defined by the isolation layer 11. In this case, for example, the power supply connection part 10, the first electrode contact part 8, and the second electrode contact part 9 each include a single layer of film, and are made of a same material and are of an integrated structure.

The power supply connection part 10, the first electrode contact part 8, and the second electrode contact part 9 have simple structures, and are easy to prepare, thereby helping simplify the preparation method for the integrated circuit, and improve preparation efficiency of the integrated circuit.

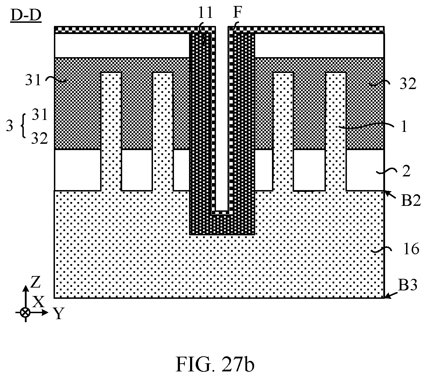

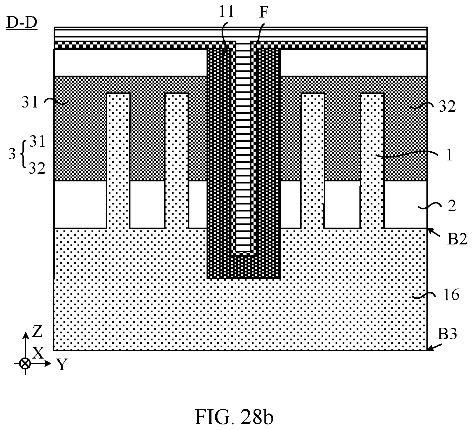

In addition, the power supply connection part 10, the first electrode contact part 8, and the second electrode contact part 9 each may alternatively be formed by stacking a plurality of film layers. In this case, as shown in FIG. 27a(a) and FIG. 27a(b), FIG. 27b, FIG. 28a(a) and FIG. 28a(b), and FIG. 28b, before the first trench G1, the second trench G2, and the opening K are filled with the conductive material, the preparation method further includes: forming a barrier film F that covers at least a side wall of the first trench G1, a side wall of the second trench G2, and a side wall of the opening K. When the power supply connection part 10 is in contact with the first electrode contact part 8, the barrier film F surrounds the power supply connection part 10 and the first electrode contact part 8. When the power supply connection part 10 is in contact with the second electrode contact part 9, the barrier film F surrounds the power supply connection part 10 and the second electrode contact part 9. When the power supply connection part 10 is in contact with the first electrode contact part 8 and the second electrode contact part 9, the barrier film F surrounds the power supply connection part 10, the first electrode contact part 8, and the second electrode contact part 9.

A material of the barrier film F includes but is not limited to one or more of titanium, titanium nitride, tantalum, tantalum nitride, and the like.

The barrier film F further covers the sixth dielectric layer 17, the bottom wall of the first trench G1, a bottom wall of the second trench G2, and a bottom wall of the opening K. The barrier film F is in contact with a bottom surface and a side surface of the power supply connection part 10, in contact with a bottom surface and a side surface of the first electrode contact part 8, and in contact with a bottom surface and a side surface of the second electrode contact part 9. For example, in FIG. 28a(a) and FIG. 28a(b) and FIG. 28b, a portion that is of the barrier film F and that is located in the first trench G1 is U-shaped, and the power supply connection part 10 is located in a region enclosed by the barrier film F. A portion that is of the barrier film F and that is located in the second trench G2 is U-shaped, and the first electrode contact part 8 or the second electrode contact part 9 is located in a region enclosed by the barrier film F.

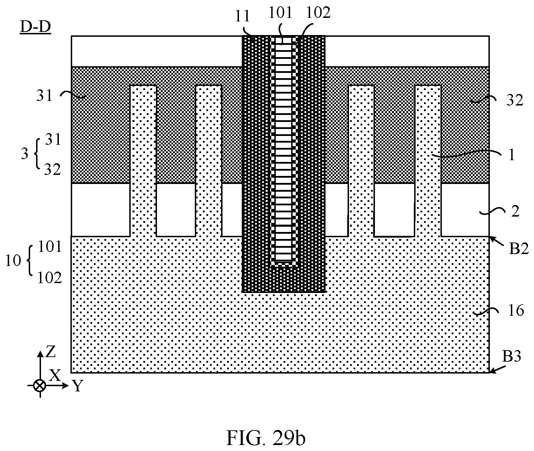

With reference to FIG. 28a(a) and FIG. 28a(b), FIG. 28b, FIG. 29a(a) and FIG. 29a(b), and FIG. 29b, in a process of polishing and removing, by using the chemical mechanical polishing process, a portion of the conductive material located on the sixth dielectric layer 17, a portion that is of the barrier film F and that covers the sixth dielectric layer 17 may be further polished and removed, and a portion that is of the barrier film F and that covers the bottom wall and the side wall of the first trench G1, a portion that is of the barrier film F and that covers the bottom wall and the side wall of the second trench G2, and a portion that is of the barrier film F and that covers the bottom wall and the side wall of the opening K are retained. The portion that is of the barrier film F and that is located in the first trench G1 is configured to form the second barrier layer 102, and a portion that is of the conductive material and that is located in the first trench G1 is configured to form the second conductive layer 101. The second conductive layer 101 and the second barrier layer 102 together form the power supply connection part 10. The portion that is of the barrier film F and that is located in the second trench G2 is configured to form the first barrier layer 82 or the third barrier layer 92, and a portion that is of the conductive material and that is located in the second trench G2 is configured to form the first conductive layer 81 or the third conductive layer 91. The first conductive layer 81 and the first barrier layer 82 together form the first electrode contact part 8, and the third conductive layer 91 and the third barrier layer 92 together form the second electrode contact part 9.

Disposing the barrier film F helps improve adhesion between the conductive material and a dielectric layer (for example, the second dielectric layer 6) around the conductive material.

In some embodiments, as shown in FIG. 14b(b), for example, the second electrode 5 is exposed from the second trench G2.

As shown in FIG. 21a to FIG. 23b(a) and FIG. 23b(b), in S500, in a process of forming the power supply connection part 10, the first electrode contact part 8, and the second electrode contact part 9, a third electrode contact part 12 and a fourth electrode contact part 13 are further formed. The third electrode contact part 12 and the fourth electrode contact part 13 are located on two opposite sides of the power supply connection part 10 in the second direction Y. The third electrode contact part 12 and the fourth electrode contact part 13 are located on different second electrodes 5, and are in contact with the corresponding second electrodes 5.

A method for forming the third electrode contact part 12 and the fourth electrode contact part 13 is the same as the method for forming the power supply connection part 10, the first electrode contact part 8, and the second electrode contact part 9. For details, refer to the foregoing related descriptions. Details are not described herein again.

In this embodiment of this application, the third electrode contact part 12, the fourth electrode contact part 13, the first electrode contact part 8, the second electrode contact part 9, and the power supply connection part 10 are formed synchronously in a same patterning process, thereby helping simplify a preparation process for the integrated circuit.

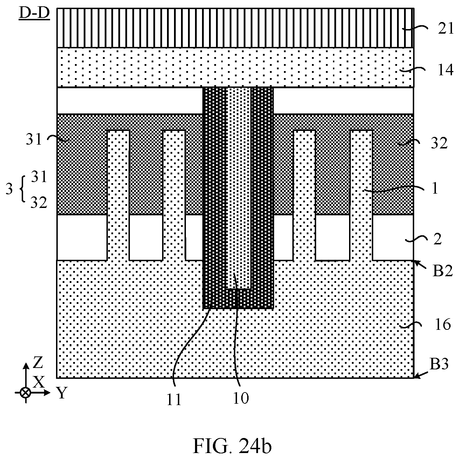

Further, as shown in FIG. 24a(a) and FIG. 24a(b) and FIG. 24b, before S600, that is, before the power delivery network 7 is formed on the side that is of the semiconductor structure 1 and that is away from the gate line 3, the preparation method further includes: forming an interconnection layer 14 on the third electrode contact part 12 and the fourth electrode contact part 13. The interconnection layer 14 is electrically connected to the third electrode contact part 12 and the fourth electrode contact part 13.

The interconnection layer 14 can transmit an electrical signal to the third electrode contact part 12 and the fourth electrode contact part 13.

In some embodiments, as shown in FIG. 24a(a) and FIG. 24a(b) and FIG. 24b, after the interconnection layer 14 is formed and before the power delivery network 7 is formed, the preparation method further includes: bonding (bonding) a carrier wafer 21 on the interconnection layer 14. The carrier wafer 21 may be configured to support the initial integrated circuit 600a.

Optionally, no element may be disposed on the carrier wafer 21. In this way, after the integrated circuit is prepared and formed, the carrier wafer 21 may be stripped and removed. Alternatively, a plurality of elements (such as a transistor, a capacitor, and a resistor) may be formed on the carrier wafer 21, and the plurality of elements on the carrier wafer 21 are electrically connected to the interconnection layer 14. In this way, after the integrated circuit is prepared and formed, the carrier wafer 21 may be used as a portion of the integrated circuit.

In the descriptions of this specification, the described specific features, structures, materials, or characteristics may be combined in a proper manner in any one or more of embodiments or examples. The foregoing descriptions are merely specific implementations of this application, but are not intended to limit the protection scope of this application. Any variation or replacement readily figured out by a person skilled in the art within the technical scope disclosed in this disclosure shall fall within the protection scope of this application. Therefore, the protection scope of this application shall be subject to the protection scope of the claims.

## Claims

1. An integrated circuit, wherein the integrated circuit comprises:
a power delivery network having a first surface;
a plurality of semiconductor structures, located on the first surface, wherein the plurality of semiconductor structures extend in a first direction and are spaced apart in a second direction, and both the first direction and the second direction are parallel to the first surface and intersect with each other;
a gate line, disposed across the plurality of semiconductor structures, wherein the gate line extends in the second direction;
a first electrode, in contact with the semiconductor structure, wherein the first electrode is located on a side of the gate line in the first direction;
a power supply connection part, located between two adjacent semiconductor structures, wherein the power supply connection part is in contact with the power delivery network, and the power supply connection part extends in the first direction to divide the gate line into a first sub-gate line and a second sub-gate line;
a first electrode contact part and a second electrode contact part, located on two opposite sides of the power supply connection part in the second direction, wherein the first electrode contact part and the second electrode contact part are located on different first electrodes and are in contact with the corresponding first electrodes; and
an isolation layer, located at least on the two opposite sides of the power supply connection part in the second direction, to isolate the power supply connection part from the first sub-gate line and the second sub-gate line, wherein
the power supply connection part further penetrates the isolation layer and is in contact with the first electrode contact part and/or the second electrode contact part.

2. The integrated circuit according to claim 1, wherein the first electrode contact part, the second electrode contact part, and the power supply connection part are disposed at a same layer.

3. The integrated circuit according to claim 1 or 2, wherein the power supply connection part is in contact and is of an integrated structure with the first electrode contact part; or
the power supply connection part is in contact and is of an integrated structure with the second electrode contact part; or
the power supply connection part is in contact and is of an integrated structure with the first electrode contact part and the second electrode contact part.

4. The integrated circuit according to any one of claims 1 to 3, wherein the first electrode contact part comprises a first conductive layer and a first barrier layer, and the power supply connection part comprises a second conductive layer and a second barrier layer; and
when the power supply connection part is in contact with the first electrode contact part,
the first conductive layer and the second conductive layer are connected to each other and are of an integrated structure; and
the first barrier layer and the second barrier layer are connected to each other and are of an integrated structure, and the first barrier layer and the second barrier layer jointly surround the first conductive layer and the second conductive layer.

5. The integrated circuit according to any one of claims 1 to 4, wherein the power supply connection part comprises a second conductive layer and a second barrier layer, and the second electrode contact part comprises a third conductive layer and a third barrier layer; and
when the power supply connection part is in contact with the second electrode contact part,
the second conductive layer and the third conductive layer are connected to each other and are of an integrated structure; and
the second barrier layer and the third barrier layer are connected to each other and are of an integrated structure, and the second barrier layer and the third barrier layer jointly surround the second conductive layer and the third conductive layer.

6. The integrated circuit according to any one of claims 1 to 5, wherein the first electrode contact part comprises the first conductive layer and the first barrier layer, the power supply connection part comprises the second conductive layer and the second barrier layer, and the second electrode contact part comprises the third conductive layer and the third barrier layer; and
when the power supply connection part is in contact with the first electrode contact part and the second electrode contact part,
the first conductive layer, the second conductive layer, and the third conductive layer are connected to each other and are of an integrated structure; and
the first barrier layer, the second barrier layer, and the third barrier layer are connected to each other and are of an integrated structure, and the first barrier layer, the second barrier layer, and the third barrier layer jointly surround the first conductive layer, the second conductive layer, and the third barrier layer.

7. The integrated circuit according to any one of claims 1 to 6, wherein a material of the isolation layer comprises at least one of silicon nitride, silicon carbide, silicon carbonitride, or silicon oxynitride.

8. The integrated circuit according to any one of claims 1 to 7, wherein a surface on a side that is of the isolation layer and that is close to the power delivery network is flush with a surface on a side that is of the power supply connection part and that is close to the power delivery network.

9. The integrated circuit according to any one of claims 1 to 8, wherein the integrated circuit further comprises:
a second electrode, in contact with the semiconductor structure, wherein the second electrode and the first electrode are located on two opposite sides of the gate line in the first direction;
a third electrode contact part and a fourth electrode contact part, located on the two opposite sides of the power supply connection part in the second direction, wherein the isolation layer isolates the power supply connection part from the third electrode contact part, and isolates the power supply connection part from the fourth electrode contact part; and the third electrode contact part and the fourth electrode contact part are located on different second electrodes and are in contact with the corresponding second electrodes; and
an interconnection layer, located on the third electrode contact part and the fourth electrode contact part, and electrically connected to the third electrode contact part and the fourth electrode contact part.

10. The integrated circuit according to claim 9, wherein the third electrode contact part, the fourth electrode contact part, and the power supply connection part are disposed at a same layer.

11. The integrated circuit according to any one of claims 1 to 10, wherein the integrated circuit further comprises at least two dummy gate lines, and the dummy gate lines extend in the second direction; and
the gate line is located between two adjacent dummy gate lines, and the power supply connection part further divides the dummy gate lines.

12. A preparation method for an integrated circuit, wherein the preparation method comprises:
forming an initial integrated circuit, wherein the initial integrated circuit comprises a plurality of semiconductor structures, a first dielectric layer, a gate line, and a first electrode; the plurality of semiconductor structures extend in a first direction and are spaced apart in a second direction; the first dielectric layer is filled between two adjacent semiconductor structures; the gate line is disposed across the plurality of semiconductor structures and extends in the second direction; the first electrode is in contact with the semiconductor structure; and the first electrode is located on a side of the gate line in the first direction;
forming a first trench between two adjacent semiconductor structures, wherein the first trench penetrates the gate line and the first dielectric layer; and the first trench extends in the first direction to cut the gate line into a first sub-gate line and a second sub-gate line;
forming an isolation layer in the first trench, wherein the isolation layer covers a side wall of the first trench;
forming an opening in the isolation layer;
forming a power supply connection part, a first electrode contact part, and a second electrode contact part, wherein the power supply connection part is located in the first trench, and the first electrode contact part and the second electrode contact part are located on two opposite sides of the power supply connection part in the second direction; the first electrode contact part and the second electrode contact part are located on different first electrodes and are in contact with the corresponding first electrodes; and the power supply connection part is in contact with the first electrode contact part and/or the second electrode contact part through the opening; and
forming a power delivery network on a side that is of the semiconductor structure and that is away from the gate line, wherein the power delivery network is in contact with the power supply connection part; and the power delivery network has a first surface, and both the first direction and the second direction are parallel to the first surface, and intersect with each other.

13. The preparation method according to claim 12, wherein the initial integrated circuit further comprises a second dielectric layer; and the second dielectric layer is located on two opposite sides of the gate line in the first direction, and covers the first electrode;
before forming the opening in the isolation layer, the preparation method further comprises:
forming a second trench in the second dielectric layer, wherein the first electrode is exposed from the second trench; the second trench is located on two opposite sides of the isolation layer in the second direction; and the second trench communicates with the first trench through the opening; and
forming the power supply connection part, the first electrode contact part, and the second electrode contact part comprises:
filling the first trench, the second trench, and the opening with a conductive material to form the power supply connection part, the first electrode contact part, and the second electrode contact part.

14. The preparation method according to claim 13, wherein before filling the first trench, the second trench, and the opening with the conductive material, the preparation method further comprises:
forming a barrier film that covers at least a side wall of the first trench, a side wall of the second trench, and a side wall of the opening, wherein when the power supply connection part is in contact with the first electrode contact part, the barrier film surrounds the power supply connection part and the first electrode contact part; or when the power supply connection part is in contact with the second electrode contact part, the barrier film surrounds the power supply connection part and the second electrode contact part.

15. The preparation method according to claim 12, wherein forming the isolation layer in the first trench comprises:
forming an isolation film, wherein the isolation film covers the gate line, and the side wall and a bottom wall that are of the first trench;
forming a third dielectric layer, wherein a portion of the third dielectric layer is filled in the first trench, and another portion of the third dielectric layer is located on a side that is of the isolation film and that is away from the gate line; and
synchronously removing portions that are of the third dielectric layer and the isolation film and that are located on the gate line, and etching the portion that is of the third dielectric layer and that is filled in the first trench.

16. The preparation method according to claim 12, wherein the initial integrated circuit further comprises a substrate, the substrate has a second surface and a third surface that are opposite to each other, and the semiconductor structure is located on the second surface; and the first trench further extends to the substrate; and
before forming the power delivery network on the side that is of the semiconductor structure and that is away from the gate line, the preparation method further comprises:
removing the substrate from a side on which the third surface is located, to expose the power supply connection part.

17. The preparation method according to claim 12, wherein the initial integrated circuit further comprises a second electrode, and the second electrode is in contact with the semiconductor structure; and the second electrode and the first electrode are located on two opposite sides of the gate line in the first direction;
in a process of forming the power supply connection part, the first electrode contact part, and the second electrode contact part, a third electrode contact part and a fourth electrode contact part are further formed, wherein the third electrode contact part and the fourth electrode contact part are located on two opposite sides of the power supply connection part in the second direction; and the third electrode contact part and the fourth electrode contact part are located on different second electrodes and are in contact with the corresponding second electrodes; and
before forming the power delivery network on the side that is of the semiconductor structure and that is away from the gate line, the preparation method further comprises:
forming an interconnection layer on the third electrode contact part and the fourth electrode contact part, wherein the interconnection layer is electrically connected to the third electrode contact part and the fourth electrode contact part.

18. An electronic device, wherein the electronic device comprises:
a circuit board; and
the integrated circuit according to any one of claims 1 to 11, wherein the integrated circuit is connected to the circuit board.
